(19) Europäisches Patentamt
European Patent Office
Office européen des brevets

(11) EP 2 159 610 B1

(12) **EUROPEAN PATENT SPECIFICATION**

(45) Date of publication and mention
of the grant of the patent:
**10.06.2015 Bulletin 2015/24**

(51) Int Cl.:
***G02B 5/30*** *(2006.01)*      ***G02F 1/13363*** *(2006.01)*
***H01L 51/52*** *(2006.01)*

(21) Application number: **07832911.7**

(22) Date of filing: **30.11.2007**

(86) International application number:
**PCT/JP2007/073246**

(87) International publication number:
**WO 2008/152756 (18.12.2008 Gazette 2008/51)**

(54) **OPTICAL ELEMENT, DISPLAY DEVICE, AND OPTICAL DEVICE**

OPTISCHES ELEMENT, ANZEIGEEINRICHTUNG UND OPTISCHE EINRICHTUNG

ELÉMENT OPTIQUE, DISPOSITIF D'AFFICHAGE ET DISPOSITIF OPTIQUE

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **15.06.2007 JP 2007158448**

(43) Date of publication of application:
**03.03.2010 Bulletin 2010/09**

(73) Proprietor: **Kaneka Corporation
Osaka (JP)**

(72) Inventors:
• **TSUKAMOTO, Michinori
Osaka 566-0072 (JP)**

• **FUJII, Sadao
Hyogo 652-0803 (JP)**
• **SEKIGUCHI, Yasuhiro
Osaka 566-0072 (JP)**

(74) Representative: **Vossius & Partner
Patentanwälte Rechtsanwälte mbB
Siebertstrasse 3
81675 München (DE)**

(56) References cited:
WO-A1-2006/010431     WO-A1-2006/028275
JP-A- 08 334 614        JP-A- 2004 139 001
JP-A- 2004 212 468      JP-A- 2006 520 928
JP-Y2- 2 587 342

**Description**

The present invention relates to an optical element that exhibits birefringence with respect to incident light, a display device including the optical element, and an optical device including the optical element.

Polymer retardation films such as stretched polycarbonate films have been used for various purposes in liquid crystal displays and EL (Electroluminescence) displays.

For example, a liquid crystal display has a problematic viewing angle characteristic such that birefringence of liquid crystal molecules causes leakage of light in a skew direction when the liquid crystal display displays black. In order to improve the viewing angle characteristic, there is a technique for providing a retardation film that optically compensates birefringence of liquid crystal molecules. For example, it is known that a retardation film of a negative C plate (nx = ny > nz; nx and ny are refractive indices in x and y directions, respectively, on a plane of a film, and nz is a refractive index in a thickness direction of the film) is effective for liquid crystal molecules in a VA mode (see KUZUHARA Noriyasu, UMEDA Hiroki, SHIBUE Toshiaki, "Development of New Retardation Film for VA-mode LCD-TVs", online, retrieved on June 7, 2007, Internet (URL: http: //konicaminolta.jp/about/research/technology_report/2006/ pdf/introduce_009.pdf) Non-patent Literature 1).

Further, in a liquid crystal display in a VA (Vertical Aligned) mode, a pair of polarization plates are positioned in such a manner that polarization axes thereof are perpendicular to each other. In this case, the polarization axes of the pair of polarization plates are perpendicular to each other when seen from a front, but they appear to cross each other with an angle of more than 90° when seen from a skew direction. Consequently, when displaying black, light leaks in a skew direction. It is known that a retardation film of a positive A plate (nx>ny=nz) is effective for compensating viewing angle dependence derived from perpendicular polarization axes.

Further, a retardation film is used as a λ/4 retardation film or a λ/2 retardation film included in a liquid crystal display or an EL display.

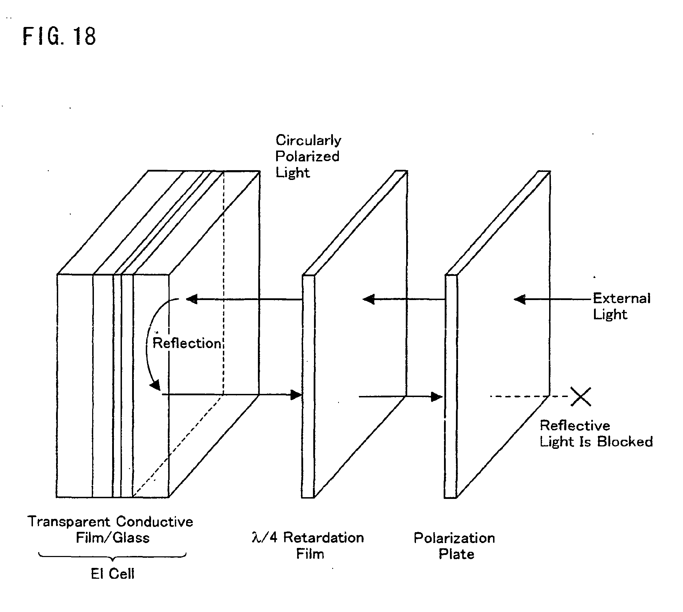

Fig. 18 shows an example of an EL display using a λ/4 retardation film for preventing reflection. As shown in Fig. 18, the EL display includes an EL cell having a transparent conductive film and glass, a λ/4 retardation film, and a polarization plate in this order. Light from the outside is polarized by the polarization plate to linearly polarized light, and then converted by the λ/4 retardation film into circularly polarized light. The circularly polarized light is reflected by the EL cell, and passes through the λ/4 retardation film again. Consequently, the linearly polarized light emitted from the polarization plate passes through the λ/4 retardation film twice by being reflected by the EL cell, and thus converted into linearly polarized light whose polarization axis is rotated by 90° with respect to that of the linearly polarized light emitted from the polarization plate. That is, the polarization axis of the linearly polarized light having been reflected by the EL cell and having passed through the λ/4 retardation film is perpendicular to the polarization axis of the polarization plate. Consequently, the light having been reflected by the EL cell is blocked by the polarization plate and does not leak to the outside.

As described above, the retardation film is used for various purposes.

On the other hand, it is known that birefringence An has a property of changing according to wavelengths (wavelength dispersion or wavelength dependence), and wavelength dispersion of birefringence is represented by equation (a).

$$\Delta n = A + \frac{B}{\lambda^2 - C^2}$$

... equation (a)

λ: wavelength
A, B, C: constant

Most of polymer materials such as polycarbonate and polyarylate exhibit normal dispersion in which birefringence Δn gets larger as wavelength gets shorter. Retardation Re is represented by the following equation.

$$Re = \Delta n \times d$$

where An is birefringence and d is a thickness.

Consequently, retardation shows wavelength dispersion similar to that of birefringence. That is, wavelength dispersion of retardation of most of retardation films themselves is normal dispersion.

Wavelength dispersion of retardation of a retardation film is an important factor that influences display performance of a display. For example, in a case where birefringence of liquid crystal molecules themselves is optically compensated by a retardation film as described above, optically compensating birefringence in all wavelengths requires making wavelength dispersion of birefringence of the liquid crystal molecules equal to wavelength dispersion of optical dispersion of the retardation film. Otherwise, light leaks depending on a wavelength when displaying black.

Further, in a case of using a λ/4 retardation film in order to prevent reflection of natural light from the outside as in Fig. 18, it is preferable that wavelength dispersion of the retardation film is set such that retardation is 1/4 of each wavelength of light in a visible light region. Otherwise, although reflection of light with a specific wavelength can be prevented, reflective light with other wavelengths leaks.

For this reason, there has been developed a technique for controlling wavelength dispersion of retardation of a retardation film.

FUJII Sadao, "Requested Properties and Material Design of Polymer Retardation Film", Ekisyo (Liquid Crystal), Vol. 9, No. 4, p227-236, 2005 (Non-patent Literature 2) discloses a technique of controlling wavelength dispersion by laminating a plurality of retardation films. In the technique, a plurality of films with the same wavelength dispersion are attached to each other in such a manner that slow axes thereof form a predetermined angle or two kinds of films with different wavelength dispersion are attached to each other.

Further, JP-2001-249222 A (Patent Literature 1) discloses a technique of copolymerizing monomers with different wavelength dispersion so as to realize a film with reverse wavelength dispersion (i.e. retardation gets smaller as wavelength gets shorter).

In addition to this, there is known a technique of holographic retarder in which rectangular lattice with a pitch of 300-350nm is formed on a surface and wavelength dispersion of retardation is controlled using structural birefringence. Further, JP-U-2587342 Y (Patent Literature 2) discloses a technique relating to a structural birefringence element.

JP-08-334619 A (Patent Literature 3) discloses a technique in which three kinds of areas with different retardations respectively corresponding to pixels of three primary colors such as RGB that constitute color display are provided and retardations are set to individual primary colors in order to deal with wavelength dispersion of birefringent light. Similarly, JP-07-43707 A and JP-2006-520-928 A (Patent Literatures 4 and 5), B.M.I van der Zande, A.C.Nieuwkerk, M.van Deurzen, C.A.Renders, E. Peeters, and S.J.Roosendaal, "14.2: Technologies Towards Patterned Optical Foils", SID 03 DIGEST 194 (Non-patent Literature 3) and WO-2006-028275 A1 used for the two part delimitation of appended claim 1, disclose techniques in which three kinds of areas with different retardations are provided and display colors of individual areas are changed. These techniques utilize retardations of individual areas.

However, in a case of attaching a plurality of retardation films with an adherent etc. as in Non-patent Literature 2, a yield ratio drops and a retardation film gets thick as a whole. In addition, a rolled film cannot be produced.

In a case of copolymerizing a plurality of monomers as in Patent Literature 1, retardation occurs depending on difference in birefringence between monomers, and therefore retardation is less likely to occur as a whole. Accordingly, in order to obtain desired retardation, it is necessary to make a retardation film thicker.

Further, if wavelength dispersion is controlled by a material, properties other than the wavelength dispersion are also determined by the material. An example of properties that influence display performance is photoelastic birefringence. The photoelastic birefringence indicates a change in birefringence when stressed, and is represented by a photoelastic constant. If the photoelastic constant is large, display may be worsened due to stress caused when attaching a retardation film to a liquid crystal panel etc. Accordingly, the material is limited, and consequently even if wavelength dispersion is controlled, other properties may not be obtained. That is, the material constrains design of the retardation film.

Further, the technique of holographic retarder is problematic in that the technique requires precise and microfabrication in nano level, and that since attachment of foreign matters such as dusts changes retardation, it is necessary to prevent the attachment of foreign matters.

The present invention was made in view of the foregoing problems. An object of the present invention is to realize an optical element capable of easily controlling wavelength dispersion of retardation, without being constrained by a material. This object is achieved with the features of the claims.

In particular an optical element of the present invention includes a plurality of unit areas in a direction parallel to a light-incident plane of the optical element, the unit areas including a plurality of unit areas whose retardation with respect to light of a certain wavelength is different by 10nm or more from retardation of adjacent unit areas with respect to light of the certain wavelength, the optical element utilizing a difference in wavelength dependence between retardation $r(n, \lambda)$ of each of the unit areas and synthetic retardation $R(\lambda)$ of a whole area including all of the unit areas.

$r(n, \lambda)$ indicates retardation of an $n^{th}$ unit area with respect to light of λnm in wavelength and $R(\lambda)$ is synthetic retardation with respect to light of λnm in wavelength. The retardation here is retardation measured when seen from a direction perpendicular to the light-incident plane. In the present specification, unless an angle with respect to the light-incident plane is specified, "retardation" indicates retardation measured when seen from a direction perpendicular to the light-incident plane.

The synthetic retardation here is retardation measured when macroscopically seeing the whole area. "Utilize" indicates utilizing wavelength dependence of synthetic retardation while regarding the whole area as one element.

With the arrangement, when a distance between the optical element and a human seeing the optical element is secured so that the human cannot recognize a unit area, the human macroscopically see the whole area. That is, when the human see the optical element with a distance that does not enable the human to recognize a unit area, the human macroscopically sees the optical element as exhibiting wavelength dispersion of synthetic retardation.

Here, the synthetic retardation $R(\lambda)$ exhibits retardation corresponding to an average of birefringences derived from retardations $r(n, \lambda)$ of individual unit areas. Here, even when plural objects have the same retardation, if lights with different wavelengths are incident to the objects, respectively, the objects exhibit different birefringences.

An example of a feature value indicative of birefringence is transmittance $I(\theta, \lambda)$ at wavelength $\lambda$, which is obtained when disposing a film with retardation $r_e$ between two polarization plates whose polarization axes are parallel to each other (parallel Nicols) in such a manner that a slow axis of the film and transmission axes of the polarization plates form an angle of $\theta$. The transmittance is represented by equation below.

$$I(\theta, \lambda) = \cos^4\theta + \sin^4\theta + 1/2 \cdot \cos(2\pi r_e/\lambda) \cdot \sin^2(2\theta)$$

If $\theta$ is 45°, the transmittance is represented by trigonometric function as follows.

$$I(\lambda) = 1/2 + 1/2 \cdot \cos(2\pi r_e/\lambda)$$

It should be noted that cycle of the trigonometric function varies depending on a wavelength. While retardations of individual unit areas do not change their values regardless of a wavelength, synthetic retardation changes depending on a wavelength. On the other hand, there is a case where while retardations of individual unit areas exhibit normal wavelength dispersion, synthetic retardation does not change depending on a wavelength. That is, wavelength dependence of retardation $r(n, \lambda)$ of each of the unit areas is different from wavelength dependence of synthetic retardation $R(\lambda)$ of a whole area including all the unit areas.

Wavelength dependence (wavelength dispersion) of the synthetic retardation is determined by retardations of individual unit areas and area ratios of the individual unit areas to a whole area. Accordingly, it is possible to easily control wavelength dispersion of the synthetic retardation without being constrained by a material.

Further, since the wavelength dispersion of the synthetic retardation of the whole area can be controlled by the retardations and area ratios of the individual unit areas, the synthetic retardation is not constrained by a material. That is, it is possible to select a material so that characteristics other than wavelength dispersion have desired values.

As described above, the present invention utilizes wavelength dependence of synthetic retardation $R(\lambda)$ obtained when macroscopically seeing a whole area as one element. Therefore, the present invention is different from a configuration in which three areas with different retardations corresponding to display cells of three primary colors are provided and the retardations of the individual areas are used for respective display cells without being synthesized with retardations of other areas as in Patent Literatures 3-5 and Non-patent Literature 3.

Further, it is confirmed that the arrangement of the present invention improves viewing angle characteristic.

The shape of the optical element is not particularly limited, but it is general that the optical element is used in the form of a film, a sheet, or a plate.

Further, in a case where a plurality of unit areas with at least one of birefringence and a thickness being different among the unit areas are provided cyclically and successively, the optical element may be expressed as follows: an optical element of the present invention has a form of a plane so as to cause even retardation in the plane, the optical element being designed such that the plane is a light-incident plane, and in at least one direction on the plane, there are repeated cycles each successively having a plurality of unit areas with at least one of birefringence and a thickness being different among the unit areas, at least one of the unit areas being a birefringent area, wavelength dependence of synthetic retardation $R(\lambda)$ when light flux passes through the optical element at a spot including one or more of the cycles is substantially different from wavelength dependence of retardation $r(n, \lambda)$ when light flux passes through individual unit areas in each of said one or more of the cycles, where $r(n, \lambda)$ indicates retardation of an $n^{th}$ unit area with respect to light of $\lambda$nm in wavelength and $R(A)$ is synthetic retardation with respect to light of $\lambda$nm in wavelength.

In each cycle, the plurality of unit areas with at least one of birefringence and a thickness being different among the unit areas have respective fixed orders and sizes.

With the arrangement, wavelength dependence of synthetic retardation $R(\lambda)$ when light flux passes through the optical element at a spot including one or more of the cycles is substantially different from wavelength dependence of retardation $r(n, \lambda)$ when light flux passes through individual unit areas in each of said one or more of the cycles. That is, the synthetic retardation measured when macroscopically seeing a retardation film is different from wavelength dependence (wavelength dispersion) of retardation of a material constituting individual unit areas. This allows easily controlling wavelength dispersion of synthetic retardation without being constrained by a material.

Further, since the optical element of the present invention is mainly used in a display device, the optical element may be expressed as follows: an optical element of the present invention is an optical element, which is used in a display device including a member where display cells are arrayed, and which includes a plurality of unit areas in a direction parallel to a light-incident plane of the optical element, the unit areas including a plurality of unit areas whose retardation with respect to light of a certain wavelength is different by 10nm or more from retardation of adjacent unit areas with respect to light of the certain wavelength, plural number of unit areas out of the unit areas facing each of the display cells, wavelength dependence of retardation r(n, λ) of each of the unit areas being different from wavelength dependence of synthetic retardation R(λ) of a whole area including all of the unit areas.

Further, when a plurality of unit areas with at least one of birefringence and a thickness being different among the unit areas are provided cyclically, the optical element of the present invention may be expressed as follows: an optical element, having a form of a plane, used as retardation plate provided at a viewer side or opposite side of a liquid crystal layer of a liquid crystal display device including display cells, the optical element being designed such that the plane is a light-incident plane, and in at least one direction on the plane, there are repeated cycles each successively having a plurality of unit areas with at least one of birefringence and a thickness being different among the unit areas, at least one of the unit areas being a birefringent area, and one or more of the cycles corresponding to each of the display cells of the liquid crystal display device.

Here, the display cell indicates the minimum display unit. For example, when one pixel includes three areas corresponding to RGB, the individual RGB areas are regarded as display cells. One display cell includes a plurality of unit areas. When plural kinds of unit areas are arrayed cyclically, one display cell includes one or more cycles. Consequently, the optical element exhibits, in each display cell, birefringence of synthetic retardation R(λ). That is, the optical element serves as an optical element exhibiting wavelength dispersion of synthetic retardation. As described above, the optical element of the present invention is designed such that one display cell includes a plurality of unit areas with different retardations, and wavelength dispersion of synthetic retardation of the plurality of unit areas as a whole is utilized. Therefore, as described above, the technical idea of the present invention is entirely different from the technical ideas of Patent Literatures 3-5 and Non-patent Literature 3 in which areas each with the same size as a display cell and with the same retardation are provided so as to correspond to

RGB display cells, respectively.

The optical element of the present invention may be arranged so that the wavelength dependence of the synthetic retardation R(λ) meets equation (1).

$$R(447) \leq R(548) \leq R(628) \qquad \dots \text{equation (1)}$$

This allows easily realizing an optical element with reverse wavelength dispersion and allows controlling the degree of wavelength dispersion. Further, this allows easily realizing an optical element that exhibits larger reverse wavelength dispersion, i.e., wavelength dispersion with larger inclination in a graph whose longitudinal axis indicates retardation and whose lateral axis indicates wavelength, compared with a conventional technique of controlling wavelength dispersion by a material.

It is preferable to arrange the optical element of the present invention such that the wavelength dependence of the synthetic retardation R(λ) and the wavelength dependence of retardation r(n, λ) of at least one of the unit areas meet equation (2).

$$R(548) - R(447) > r(n, 548) - r(n, 447) \qquad \dots \text{equation (2)}$$

It is preferable to arrange the optical element of the present invention such that the wavelength dependence of the synthetic retardation R(λ) and the wavelength dependence of retardation r(n, λ) of at least one of the unit areas meet equation (3).

$$R(628) - R(548) > r(n, 628) - r(n, 548) \qquad \dots \text{equation (3)}$$

Consequently, in a graph whose longitudinal axis indicates retardation and whose lateral axis indicates wavelength, wavelength dispersion of synthetic retardation has larger inclination than wavelength dispersion of a unit area. That is, it is possible to make inclination of wavelength dispersion of synthetic retardation larger than wavelength dispersion of birefringence of a material constituting the unit area. This makes it unnecessary to consider a material when controlling wavelength dispersion, and thus provides wider selections of the material. For example, the optical element of the present invention may be arranged so that relations R(548) - R(447) > 0 and r(n, 548) - r(n, 447) < 0 are met with respect to all n.

It is preferable to arrange the optical element of the present invention such that a relation $R(550) \leq 350nm$ is met. In general, a retardation film for optical compensation of a liquid crystal display device with high-quality image requires retardation of 350nm or less. Therefore, the arrangement of the present invention is preferably applicable to such liquid crystal display device.

The optical element of the present invention may be arranged such that retardation r(n, λ) of individual unit areas and an area ratio of individual unit areas to a whole area in terms of the light-incident plane are set so that the synthetic retardation R(λ) and wavelength dependence thereof have desired values.

The optical element of the present invention may be arranged so that in a case where the optical element has a retardation of $r_e$, the optical element is positioned between a pair of polarization plates whose polarization directions are parallel to each other in such a manner that a slow axis of the optical element is rotated by 45° with respect to the polarization directions of the polarization plates, transmittance I(λ) when linearly polarized light of λ in wavelength from one of the polarization plates passes through the optical element and the other of the polarization plates and the retardation of $r_e$ with respect to light of λ in wavelength meet a relation of $I(\lambda) = 1/2 + 1/2 \cdot \cos(2\pi r_e/\lambda)$, and retardation of the unit area with respect to light of λnm in wavelength changes in a direction parallel to the light-incident plane, an average $I_{ave}$ of transmittances derived from the changing retardation is calculated, the retardation of $r_e$ that exhibits a transmittance corresponding to the average $I_{ave}$ is determined in accordance with the relation, and the retardation of $r_e$ thus determined is regarded as retardation r(n, λ) of the unit area.

It is preferable to arrange the optical element of the present invention such that each of retardations of the unit areas is substantially one of two different retardations. This facilitates production of the optical element. It should be noted that even if only several % of all the unit areas has retardation other than the two different retardations, it is considered that each of retardations of the plurality of unit areas is substantially one of two different retardations.

A difference in retardation between the unit areas should be controlled by birefringence or thickness. For example, when the unit areas are made of the same material, a thickness between adjacent unit areas should be changed.

The shape of individual unit areas is not particularly limited. For example, the optical element of the present invention may be arranged so that each of the plurality of unit areas has a rectangular shape and the unit areas are disposed in a striped manner with long sides of the unit areas being parallel to each other. It is relatively easy to produce the optical element with such disposition of unit areas. Further, a part of the plurality of unit areas may have an elliptic shape or a circular shape.

It is desirable that the optical element of the present invention has a plurality of unit areas in a region corresponding to a display cell of a display device to which the optical element is applied. Although the preferable size of a unit area varies depending on the circumstances in which the unit area exists, when the unit area exists on a stripe, the width of the unit area is preferably 100μm or less, more preferably 50μm or less, and further more preferably 20μm or less. That is, what is required here is that unit areas are seen as an average thereof when actually viewing a display device, and the absolute size of the unit area depends on a device to which the optical element is applied and the size is not limited. Here, the display cell indicates the minimum display unit (dot) of a display device. For example, in a case where one liquid crystal cell is overlapped by one of color filters corresponding to three primary colors (RGB) and three colored liquid crystal cells constitute one pixel, individual R, G, and B liquid crystal cells that are sub pixels constituting the pixel are referred to as display cells. The display cell may be an EL cell.

A difference in retardation between adjacent unit areas is preferably not less than 10nm, more preferably not less than 50nm, and further more preferably not less than 100nm. In general, optic axes of individual unit areas are preferably in the same direction. Variation in optic axis is preferably within ± 10°, more preferably within ± 5°, and further more preferably within ± 1°. If necessary, optic axes may cross each other by 90°.

When synthetic retardation exhibits reverse wavelength dispersion, the optical element of the present invention may be expressed as follows: an optical element of the present invention is an optical element, exhibiting birefringence with respect to light incident to a light-incident plane of the optical element, N (N is an integer of 2 or more) areas including a first area to an $N^{th}$ area having different retardations with respect to light of a same wavelength are provided in a direction parallel to the light-incident plane, when two wavelengths within a visible region are λ1 and λ2 (λ1 > λ2), retardation of an $n^{th}$ area (n is an integer of 1 to N) with respect to light of λ1 is r(n, λ1), retardation of the $n^{th}$ area with respect to light of λ2 is r(n, λ2), an area ratio of the $n^{th}$ area to a whole area is M(n), a feature value indicative of birefringence of the $n^{th}$ area with respect to light of λ1 is T(n, λ1), and a feature value indicative of birefringence of the $n^{th}$ area with respect to light of λ2 is T(n, λ2), retardation R(λ1) that exhibits birefringence whose feature value is represented by

$$\sum_{n=1}^{N}\left[M(n)\times T(n,\lambda 1)\right]$$

with respect to light of λ1 and retardation R(λ2) that exhibits birefringence whose feature value is represented by

$$\sum_{n=1}^{N}\left[M(n)\times T(n,\lambda 2)\right]$$

with respect to light of λ2 meet equation (4).

$$R(\lambda 1) > R(\lambda 2) \qquad \text{... equation (4)}$$

This allows easily realizing an optical element exhibiting reverse wavelength dispersion, without being constrained by a material.

Further, the display device of the present invention includes the above optical element.

For example, the display device includes a liquid crystal layer, and the optical element may be used as an optical compensation element for compensating birefringence of liquid crystal molecules of the liquid crystal layer.

By setting retardations and area ratios of unit areas, synthetic retardation of the optical element exhibits desired wavelength dispersion. This allows easily producing an optical element which is controlled to exhibit wavelength dispersion that is the same as wavelength dispersion of birefringence of liquid crystal molecules themselves. Consequently it is possible to improve the effect of optical compensation.

Further, the optical element may be used as a 1/4 wavelength plate or a 1/2 wavelength plate. A 1/4 wavelength plate ideal for natural light is required to exhibit retardation that is 1/4 of wavelength with respect to light of any wavelength at least in a visible light region. By appropriately setting retardations and area ratios of unit areas, the optical element exhibits the ideal wavelength dispersion. The same is true for the 1/2 wavelength plate. Consequently, display performance of the display device increases.

Further, it was confirmed that the optical element has excellent viewing angle characteristic. Accordingly, the optical element may be used as a viewing angle control element. This improves viewing angle characteristic of the display device.

Further, it is preferable to arrange the display device of the present invention such that at least a polarization plate, the optical element, and a member in which a plurality of display cells are arrayed are provided in this order, and the optical element includes, in a region facing each of the display cells, plural number of unit areas out of the unit areas. Although the preferable size of a unit area varies depending on the circumstances in which the unit area exists, when the unit area exists on a stripe, the width of the unit area is preferably 100μm or less, more preferably 50μm or less, and further more preferably 20μm or less. That is, what is required here is that unit areas are seen as an average thereof when actually viewing a display device, and the absolute size of the unit area depends on a device to which the optical element is applied and the size is not limited.

Brief Description of Drawings

Fig. 1

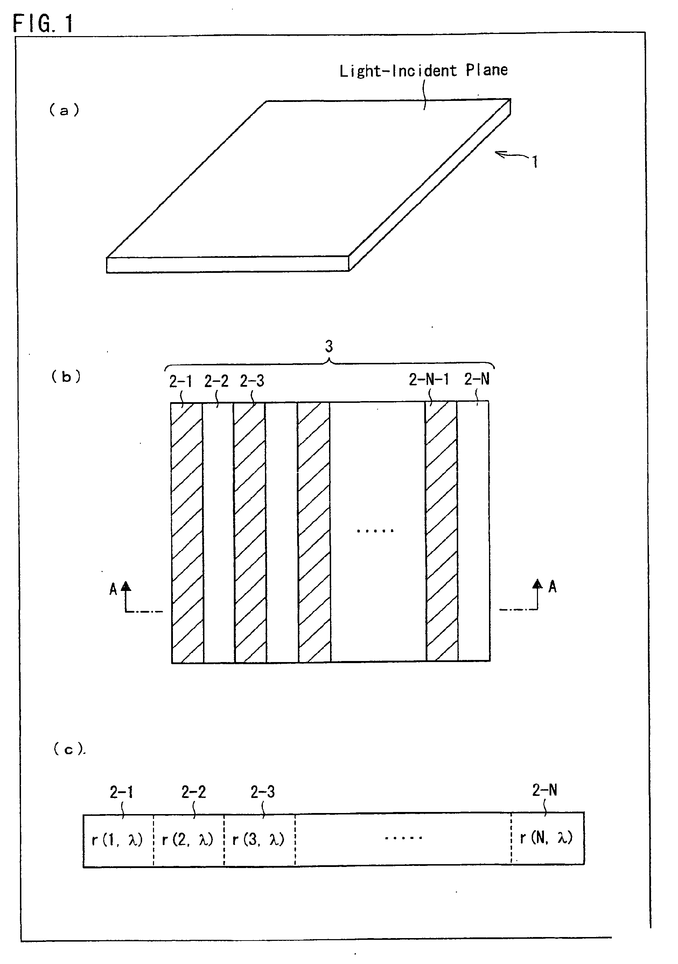

Fig. 1 is a cross-sectional drawing showing an example of a retardation film of the present embodiment. (a) of Fig. 1 is an oblique drawing, (b) of Fig. 1 is a plane drawing, and (c) of Fig. 1 is a cross sectional drawing.

Fig. 2

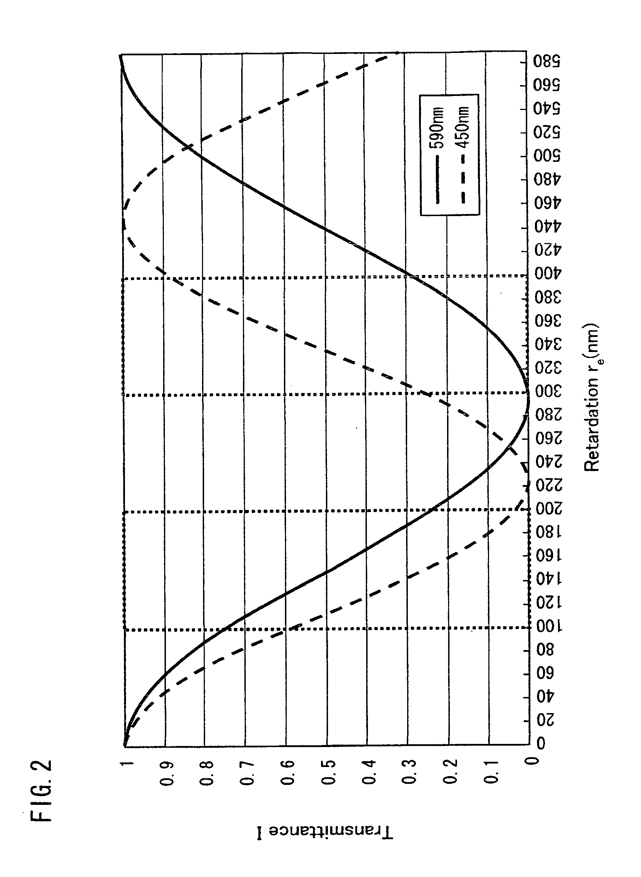

Fig. 2 is a graph showing dependence of transmittance on retardation.

Fig. 3

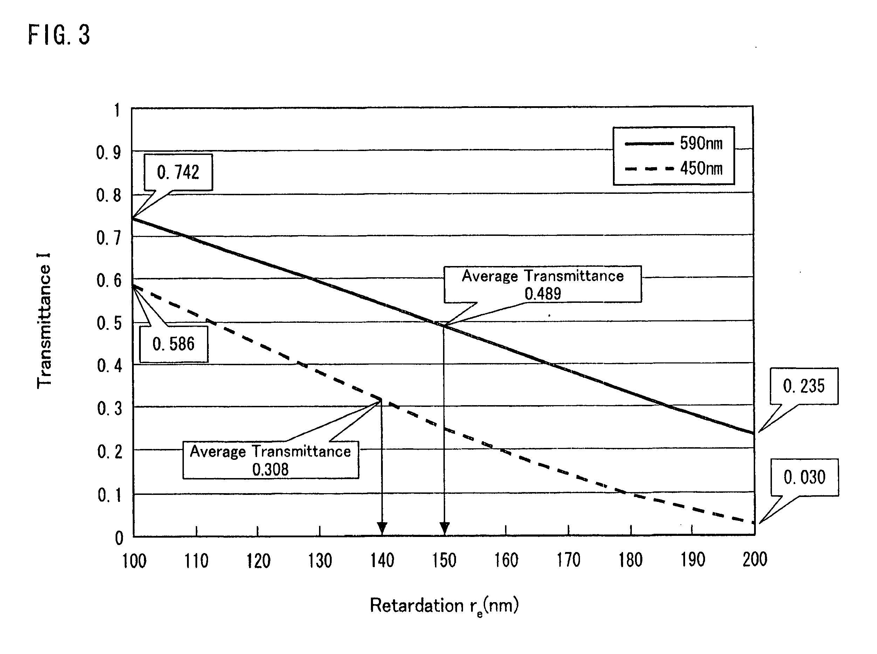

Fig. 3 is a graph showing an enlarged portion where retardation ranges from 100 to 200 nm in Fig. 2.

Fig. 4

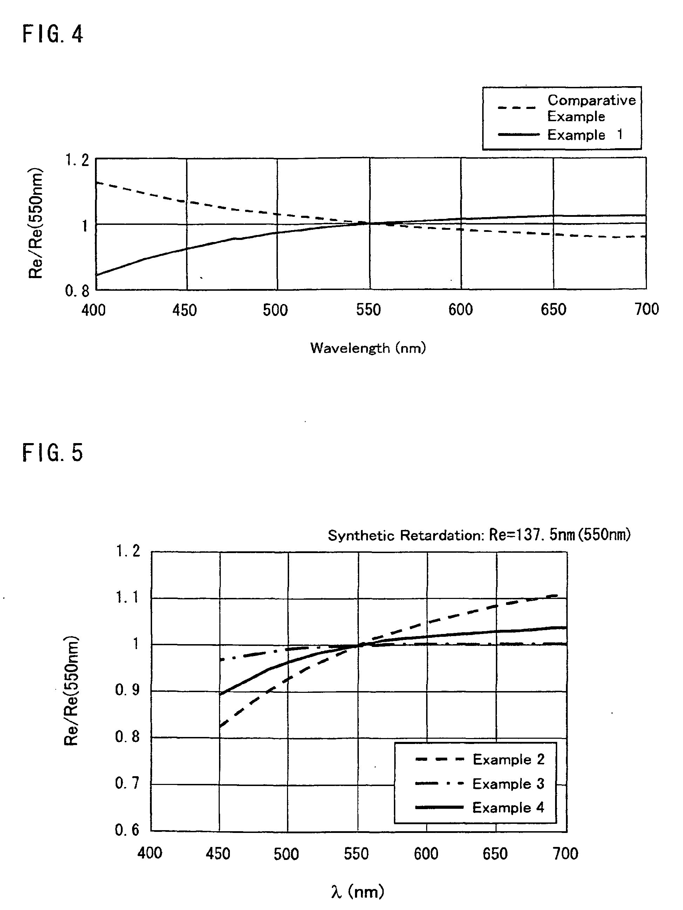

Fig. 4 is a drawing showing the result of simulation of wavelength dispersion of synthetic retardation in Example 1 of a retardation film of the present embodiment.

Fig. 5

Fig. 5 is a drawing showing the result of simulation of wavelength dispersion of synthetic retardation in Examples 2-4 of a retardation film of the present embodiment.

Fig. 6

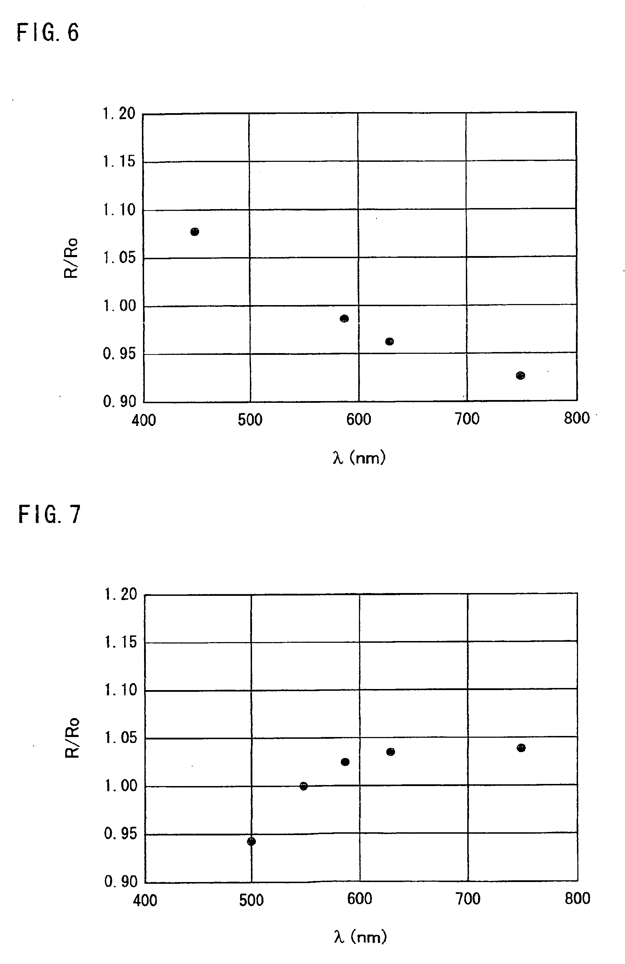

Fig. 6 is a graph showing the result of measurement of wavelength dispersion of retardation in a retardation film made of polycarbonate in which retardation is even in a direction perpendicular to a film plane.

Fig. 7

Fig. 7 is a graph showing the result of measurement of wavelength dispersion of synthetic retardation of a retardation film in which a region with retardation of λ/4 and a region with retardation of λ/2 coexist.

Fig. 8

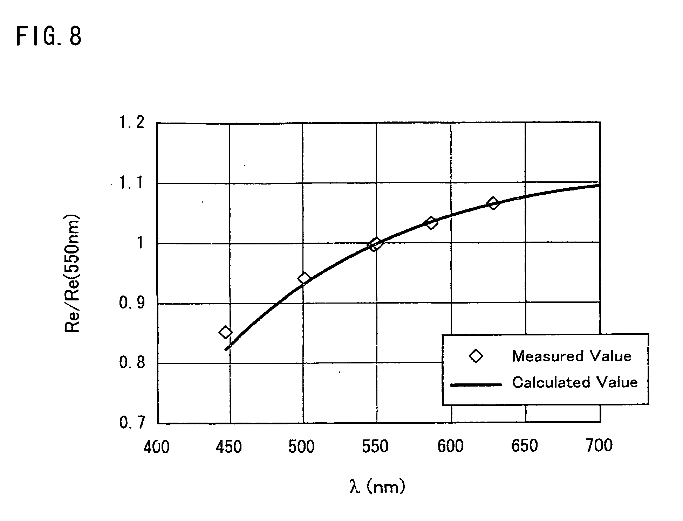

Fig. 8 is a graph showing a comparison of measured values of synthetic retardation of a retardation film and comparison with the result of simulation.

Fig. 9

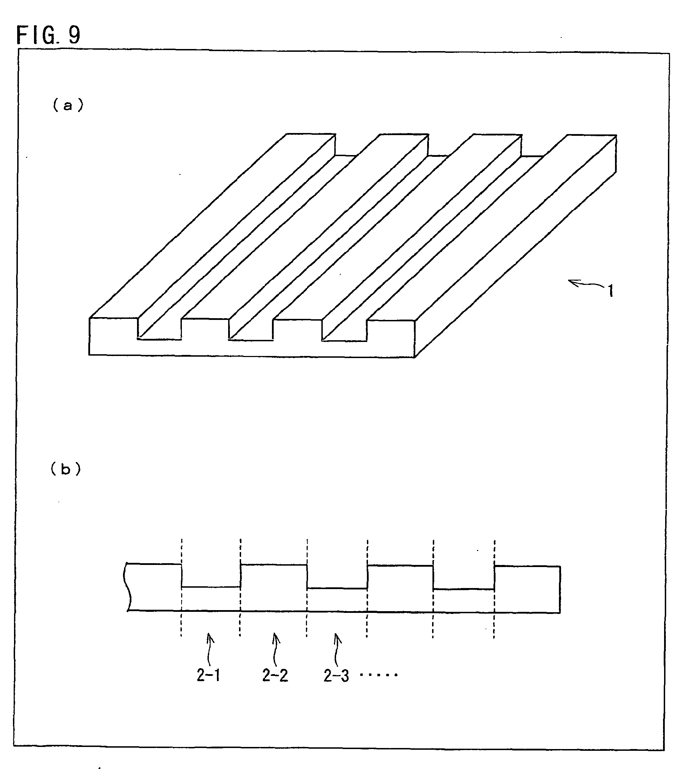

Fig. 9 is a drawing showing an example of a retardation film in which a thickness of the film is changed so as to mixedly provide unit areas with different retardations. (a) of Fig. 9 shows an oblique drawing and (b) of Fig. 9 shows a cross sectional drawing.

Fig. 10

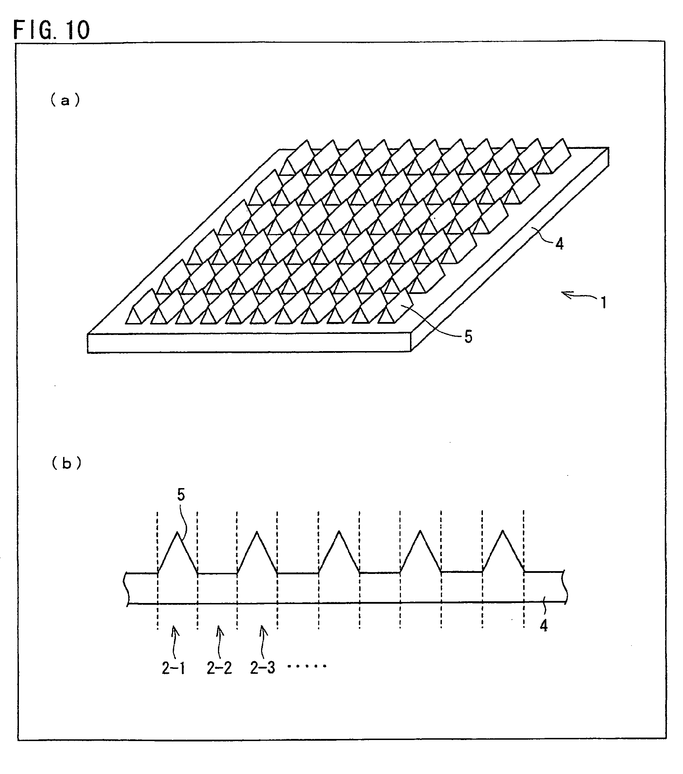

Fig. 10 is a drawing showing another example of a retardation film in which a thickness of the film is changed so as to mixedly provide unit areas with different retardations. (a) of Fig. 10 shows an oblique drawing and (b) of Fig. 10 shows a cross sectional drawing.

Fig. 11

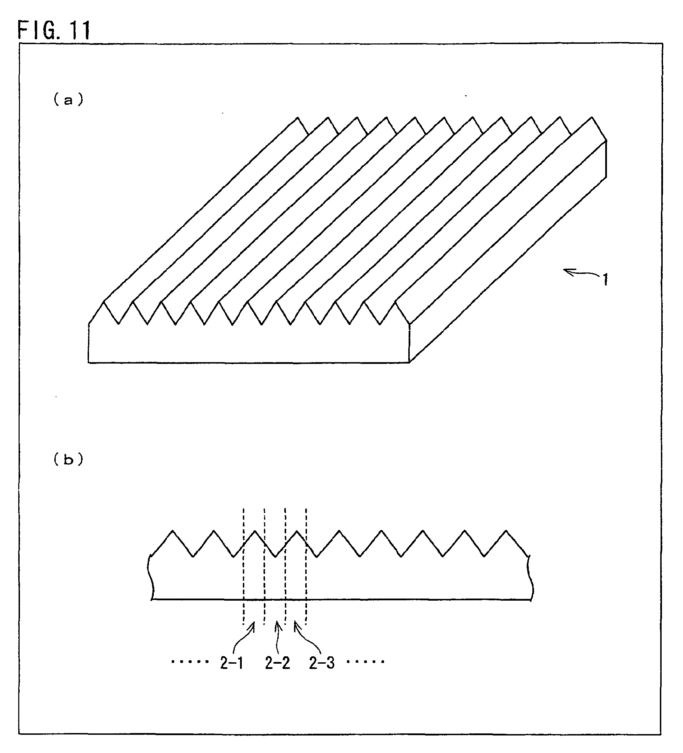

Fig. 11 is a drawing showing further another example of a retardation film in which a thickness of the film is changed so as to mixedly provide unit areas with different retardations. (a) of Fig. 11 shows an oblique drawing and (b) of Fig. 11 shows a cross sectional drawing.

Fig. 12

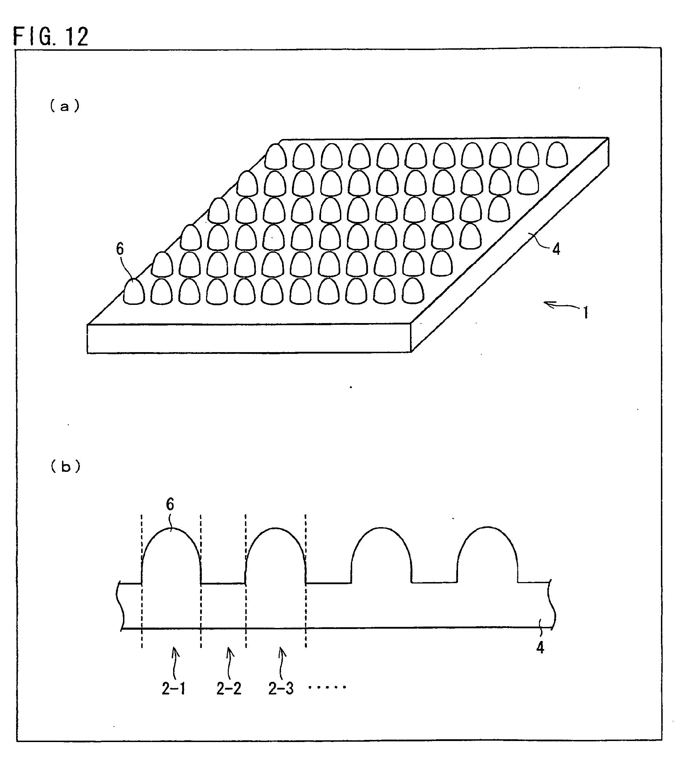

Fig. 12 is a drawing showing further another example of a retardation film in which a thickness of the film is changed so as to mixedly provide unit areas with different retardations. (a) of Fig. 12 shows an oblique drawing and (b) of Fig. 12 shows a cross sectional drawing.

Fig. 13

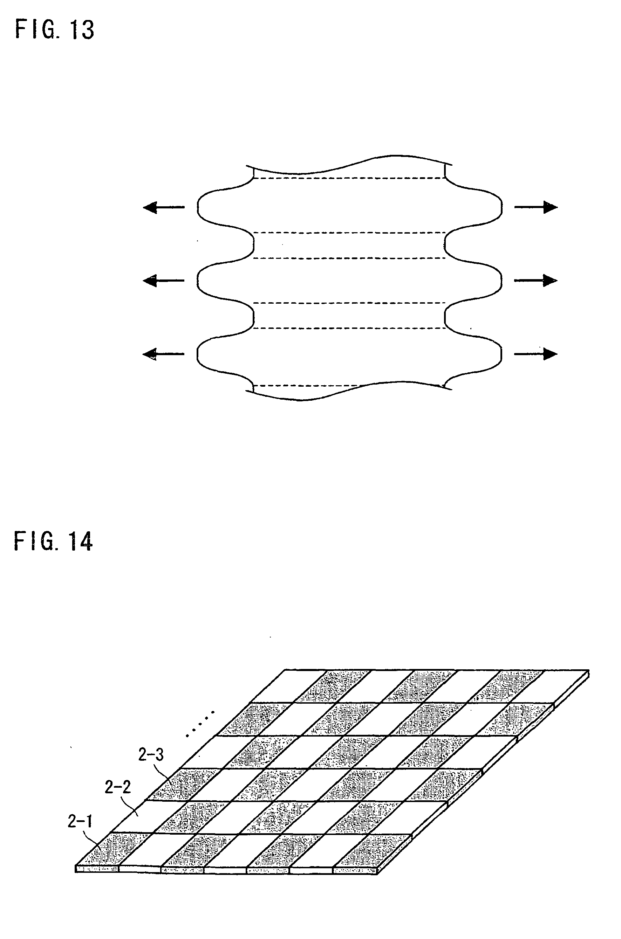

Fig. 13 is a drawing showing an example of how to produce a retardation film with partially different birefringence.

Fig. 14

Fig. 14 is a drawing showing an example of alignment of unit areas.

Fig. 15(a)

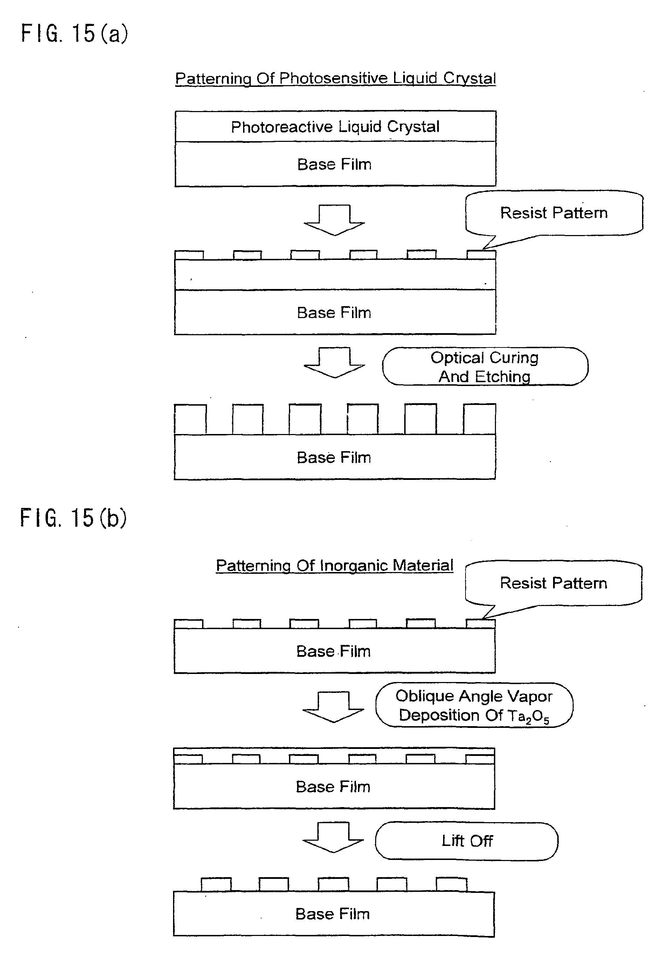

Fig. 15(a) is a drawing showing how to pattern a liquid crystal material.

Fig. 15(b)

Fig. 15(b) is a drawing showing how to pattern an inorganic material.

Fig. 16

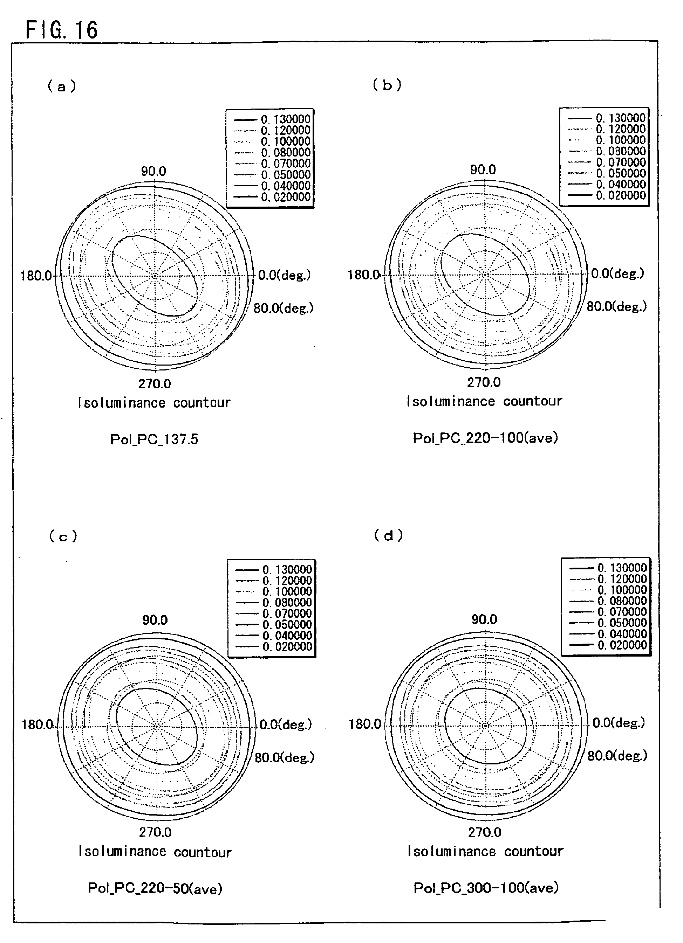

Fig. 16 is a drawing showing the result of simulation of viewing angle characteristic. (a) of Fig. 16 shows Comparative Example, (b) of Fig. 16 shows Example 3, (c) of Fig. 16 shows Example 4, and (d) of Fig. 16 shows Example 2.

Fig. 17

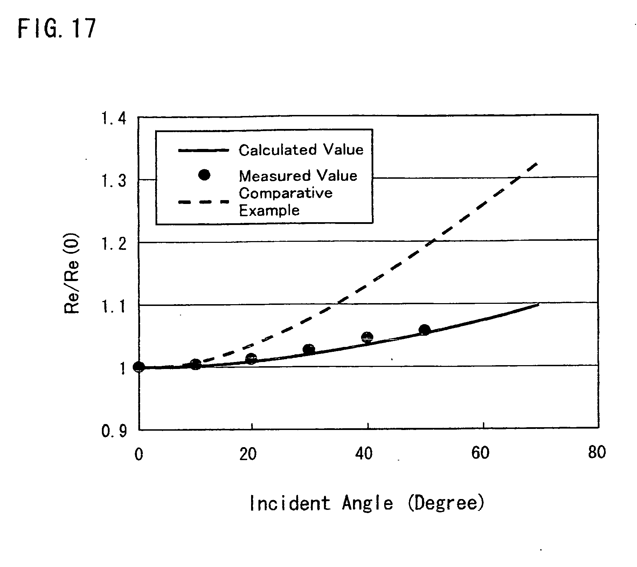

Fig. 17 is a graph showing the result of measurement of viewing angle characteristic of retardation in a retardation film of the present embodiment.

Fig. 18

Fig. 18 is a drawing showing an example of an EL display using a λ/4 retardation film for preventing reflection.

Fig. 19

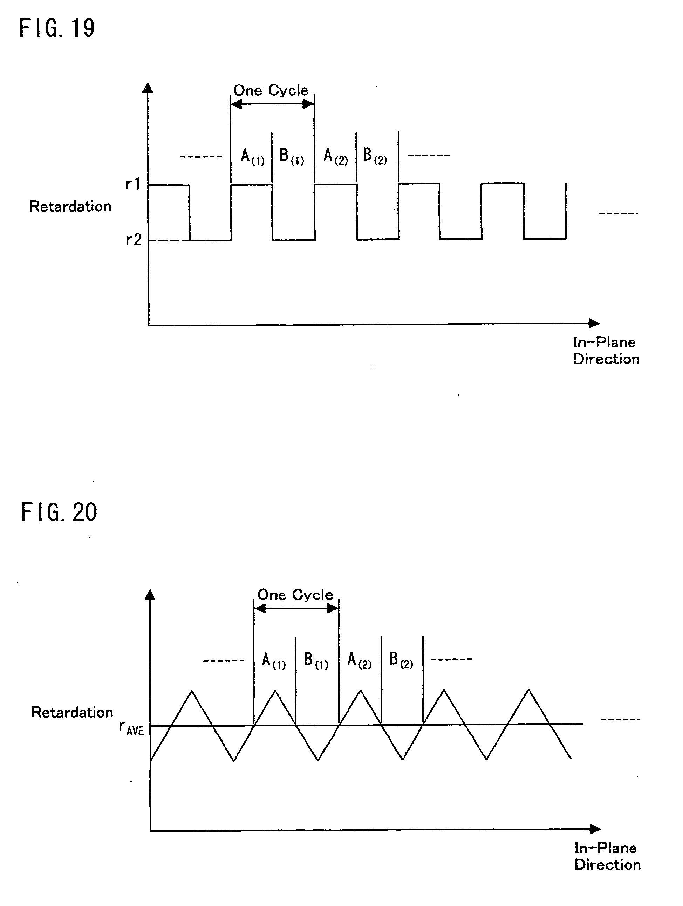

Fig. 19 is a drawing showing borders of unit areas of a retardation film in which retardation changes discontinuously.

Fig. 20

Fig. 20 is a drawing showing borders of unit areas of a retardation film in which retardation changes continuously.

Fig. 21

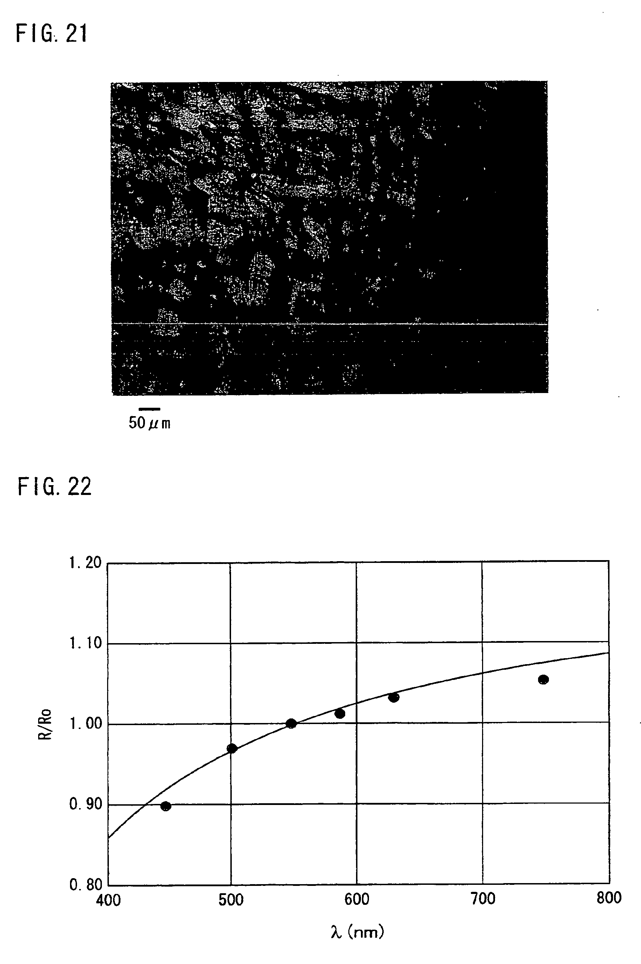

Fig. 21 is a photograph, captured by a microscope under parallel Nicols, of a blend cast film of polycarbonate/cycloolefin polymer which is produced by phase separation.

Fig. 22

Fig. 22 is a drawing showing the result of normalized synthetic retardation (synthetic retardation with respect to light of 550nm in wavelength is regarded as 1) of a whole area of a blend cast film of polycarbonate/cycloolefin polymer shown in Fig. 21.

Fig. 23

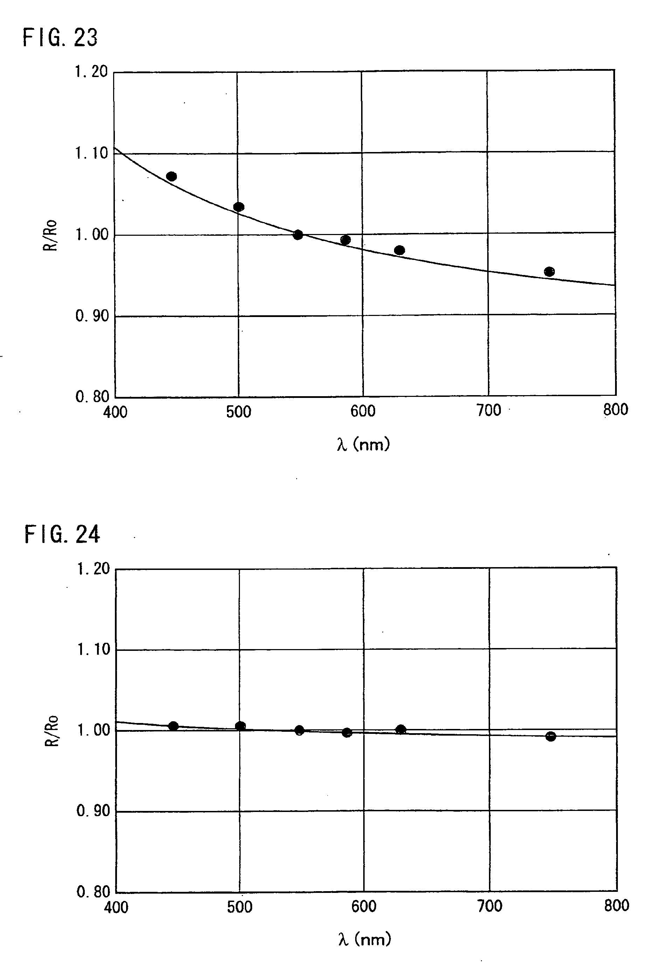

Fig. 23 is a drawing showing the result of measurement of normalized retardation (retardation with respect to light of 550nm in wavelength is regarded as 1) of a polycarbonate cast film.

Fig. 24

Fig. 24 is a drawing showing the result of normalized retardation (retardation with respect to light of 550nm in wavelength is regarded as 1) of a cycloolefin polymer cast film.

Fig. 25

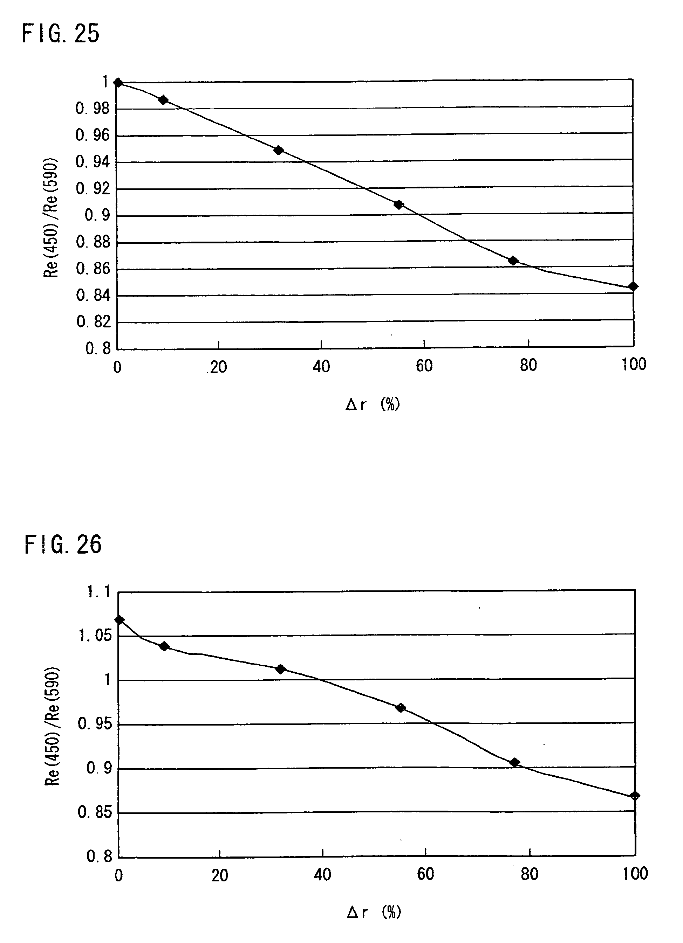

Fig. 25 is a graph showing the result of simulation of synthetic retardation of a whole area in a retardation film in which a first unit area with retardation of 220nm and a second unit area with other retardation are alternately aligned in a striped manner such that an area ratio of the first unit area to the second unit area is 1: 1.

Fig. 26

Fig. 26 is a graph showing the result of simulation of synthetic retardation of a whole area in a retardation film in which a first unit area with retardation of 220nm and a second unit area with other retardation are alternately aligned in a striped manner such that an area ratio of the first unit area to the second unit area is 0.513: 1.

Fig. 27

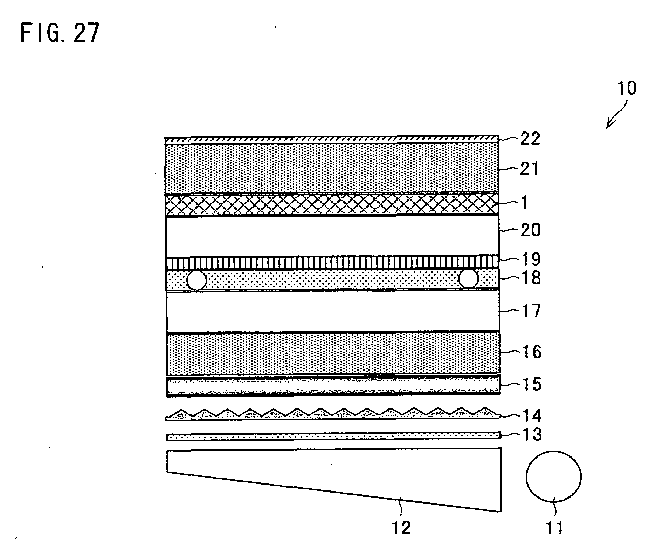

Fig. 27 is a drawing showing an example of a liquid crystal display device including the retardation film of the present Embodiment.

Reference Signs List

1: Retardation film (optical element)
2: Unit area
3: Whole area
4: Film
5, 6: Protrusion
10: Liquid crystal display device
16, 21: Polarization plate
18: Liquid crystal layer
19: Color filter

Description of Embodiments

One embodiment of an optical element of the present invention is explained below with reference to Figs. 1-27. The optical element of the present invention is mainly applicable to display devices such as liquid crystal displays and EL displays. In the present Embodiment, an explanation is made as to an optical element with a film shape, a plate shape, or a sheet shape, i.e. a planar shape. However, the present invention is not limited to this shape. For example, the present invention may be such that a surface of a substrate is processed to control retardation. Further, the optical element with a planar shape may be flexible or not flexible.

A retardation film (optical element) of the present Embodiment is used in such a manner that one plane of the film serves as a plane to which light is incident. The retardation film is designed such that retardation changes at least in one direction out of in-plane directions of the one plane (in-plane directions of the light-incident plane). The amount of change in retardation is beyond mere variation in production. That is, the retardation film has, in a direction parallel to the film plane (light-incident plane), a plurality of unit areas with different retardations with respect to light with a single wavelength. There are a plurality of unit areas whose retardations with respect to light with a single wavelength are different from those of adjacent unit areas by 10 nm or more.

The following explains how to divide the plane of the film into unit areas. In the present Embodiment, the plane of the film is divided into a plurality of unit areas so that a difference in retardation between adjacent two unit areas is as large as possible.

For example, in a case where an area with retardation r1 and an area with retardation r2 are alternately provided in one direction of a film plane as shown in Fig. 19, the plane of the film should be divided into unit areas by a boarder between the area with retardation r1 and the area with retardation r2. That is, each of areas (A(1), B(1), A(2), B(2) in the drawing) successively having the same retardation (r1 or r2) along the film plane should be set as a unit area. In Fig. 19, the area with retardation r1 and the area with retardation r2 are repeatedly provided in this order. Further, all of the areas A(1), A(2), ... have the same width. Similarly, all of the areas B(1), B(2), ... have the same width. That is, the retardation film shown in Fig. 19 is designed such that a cycle including one area A serving as a unit area and one area B serving as a unit area is repeated. In Fig. 19, the unit area has one of two retardations r1 and r2. Alternatively, the unit area has one of three or more retardations.

Alternatively, the retardation film of the present Embodiment may be arranged so that retardation continuously changes along the film plane as shown in Fig. 20. In this case, the film plane should be divided into unit areas as follows: a line connecting coordinates with an average retardation $r_{AVE}$ should be set as a boarder between unit areas. The average retardation $r_{AVE}$ is represented by

$$r_{AVE} = \frac{\iint p(x, y)\,dxdy}{A}$$

where coordinates of a position on the film plane are represented by coordinates on an X-axis and a Y-axis that are two axes on the film plane, retardation at coordinates (x, y) is represented by p(x, y), and A represents a whole area of the film plane.

With such setting, areas (A(1) and A(2) in Fig. 20) that have retardation p(x, y) of not less than average retardation $r_{AVE}$ and that are provided continuously along the film plane and areas (B(1) and B(2) in Fig. 20) that have retardation p(x, y) of less than average retardation $r_{AVE}$ and that are provided continuously along the film plane serve as unit areas. The retardation film in Fig. 20 is designed such that a cycle including one area A serving as a unit area and one area B serving as a unit area is repeated in one direction of the film plane.

In a case where retardation changes continuously along the film plane as shown in Fig. 20, retardation of individual unit areas is calculated as follows: when an optical element with retardation $r_e$ is provided between a pair of polarization plates with parallel polarization directions in such a manner that a slow axis of the optical element is rotated by 45° with respect to the polarization directions of the polarization plates, a relation between (i) transmittance I ($\lambda$) at a time when linearly polarized light of $\lambda$ in wavelength from one of the polarization plates passes through the optical element and the other of the polarization plates and (ii) the retardation $r_e$ with respect to light of $\lambda$ in wavelength is represented by an equation $I(\lambda)=1/2 +1/2 \cdot \cos(2\pi r_e/\lambda)$. An average $I_{ave}$ of transmittances derived from retardations changing in a unit area is calculated, retardation $r_e$ that exhibits transmittance of average $I_{ave}$ is determined based on the equation, and the retardation $r_e$ thus determined is regarded as retardation of the unit area.

Further, in a case of changing retardation by providing insular protrusions etc. with a predetermined distance therebetween on a film plane with even retardation, a portion where a protrusion is provided is regarded as one unit area and a portion where a protrusion is not provided is regarded as the other unit area.

In the present Embodiment, unit areas to which the film plane is divided are designed to be so minute that human eyes cannot see the unit areas. Whether the size of a unit area is so minute that human eyes cannot see the unit area or not depends on the distance, too. As the distance between a retardation film and a human seeing the retardation film is longer, the size of the unit area may be larger. The shape of the unit area is not particularly limited, and may be circular, elliptic, rectangular etc. In a case of an elliptic shape, the length of minor axis should be so short that human eyes cannot see it. In a case of a rectangular shape, the length of short side should be so short that human eyes cannot see it.

Consequently, the size of a unit area varies depending on circumstances in which a display device including a retardation film is used. For example, in a case of a display device provided in a room in a house, a human sees a screen using a retardation film from a position several ten centimeters-several meters away from the human. In a case of a display device used in a cellular phone, a human sees a screen using a retardation film from a position several ten centimeters away from the human. In a case of a display device provided in a stadium etc., a human sees a screen using a retardation film from a position several ten meters or more away from the human.

As described later, the retardation film of the present Embodiment is designed such that a plurality of unit areas with different retardations are provided along a direction parallel to a film plane and retardation when macroscopically seeing a whole area including these unit areas has a desired value. Therefore, the retardation film of the present Embodiment should be designed such that an area recognizable by human eyes includes at least two unit areas.

For example, in the case of a display device provided in a room in a house (such as liquid crystal display), the size recognizable by human eyes may be the size of display cells corresponding to RGB of a color filter used in the display device, and the size is generally 100-300 $\mu$m. Therefore, the size of a unit area is preferably 1/2 of the size of a display cell, i.e. 50 $\mu$m or less. The size of a unit area is more preferably 10 $\mu$m or less. However, as already described above, the suitable size of a unit area varies depending on the form of the unit area. For example, if the unit area has a stripe shape, the width is preferably 50$\mu$m or less but the whole length may be equal to one side of the display device. That is, a short side of the unit area with the stripe shape is preferably 50$\mu$m or less. Further, a rectangular unit area whose long sides and short sides are 50$\mu$m or less or a square unit area may be disposed in an even mosaic manner.

For example, in a case of using a retardation film in which rectangular unit areas each extending from an upper side to a lower side of a display screen are provided in a stripe manner, the length of a short side of each unit area is determined by the size of a display cell (minimum unit pixel). That is, the retardation film should be designed such that the display cell includes all kinds of unit areas so that at least one unit area exists for each kind. That is, in a case where a plurality of unit areas with different retardations are repeated cyclically, the display cell should include at least one cycle of the unit areas. For example, in a case where a display screen is 30 inches, the size of the minimum pixel is 640 × 480 dots, and a unit area has one of two retardations as shown in Fig. 19, in order that at least two unit areas exist in each dot (display cell) of three primary colors of RGB, the length of a short side of a unit area should be 160μm or less. In other words, if the length of a diagonal line of the display screen is X mm (X is an integer obtained by rounding up/down decimals) and a retardation film in which unit areas each having one of two retardations is used, it is preferable that more than 5X unit areas exist in an area corresponding to the display screen.

Fig. 1 is a drawing showing an example of a retardation film 1 of the present Embodiment. As shown in (a) of Fig. 1, the retardation film 1 of the present Embodiment- has a two-dimensional film shape, and one surface thereof serves as a light-incident plane, (b) of Fig. 1 is a plane drawing showing the retardation film seen from a direction perpendicular to the light-incident plane. (c) of Fig. 1 is a cross sectional drawing of the retardation film taken in A-A line of (b) of Fig. 1.

As shown in (b) and (c) of Fig. 1, in the retardation film 1 of the present Embodiment, a plurality of unit areas 2 (2-1, 2-2, ..., 2-N) with different retardations with respect to the same wavelength λ coexist along a direction parallel to the light-incident plane. In the cross sectional drawing, area numbers n (n=1 to N) are assigned to unit areas sequentially from one end of the film to the other end. Further, as shown in (c) of Fig. 1, retardation of a unit area of area number n with respect to light of λ in wavelength is r(n, λ).

The retardation film 1 is designed such that the unit areas 2 meet a condition that |r(n, λ)-r(n+1, λ)| which is a difference in retardation between adjacent two unit areas, i.e., areas of area number n and area number n+1, is 10nm or more. Generally, when producing a retardation film with an even thickness, retardation slightly changes along an in-plane direction of the film due to variation in production. However, such change in retardation due to variation in production is generally within 10 nm. In contrast thereto, the present Embodiment is designed such that a difference in retardation between adjacent unit areas is intentionally set to be 10 nm or more, which is not because of the change in retardation due to variation in production. That is, the present Embodiment does not use the change in retardation normally due to variation in production. What is required here is that the difference in retardation between adjacent unit areas is 10 nm or more, and two unit areas that are not adjacent to each other may have the same retardation. Generally, by evenly providing unit areas with two different retardations in the whole area of the film as shown in Fig. 19, it is possible to attain the object of the present invention. Alternatively, unit areas with three or more different retardations may be evenly provided.

In general, optic axes of individual unit areas are preferably in the same direction. Variation between optic axes is preferably within ± 10°, more preferably within ± 5°, and further more preferably within ± 1°. If necessary, optic axes may cross each other by 90°.

The retardation film 1 of the present Embodiment is designed such that by appropriately selecting retardations of individual unit areas 2 and area ratios of individual unit areas 2 to an area of a whole area 3 including all the unit areas 2, wavelength dispersion (wavelength dependence) of retardation (later-mentioned synthetic retardation) of the retardation film 1 as a whole is made different from wavelength dispersion of any unit area 2. That is, by appropriately selecting retardation r(n, λ) and an area ratio of each unit area 2, it is possible to easily produce the retardation film 1 with wavelength dispersion of desired retardation.

Wavelength dispersion of retardation has been so far determined by a material. However, in the present Embodiment, it is possible to produce the retardation film 1 with wavelength dispersion different from that of a material used in individual unit areas 2. That is, it is possible to design wavelength dispersion of retardation of an optical element as a whole without being restricted by characteristics of wavelength dispersion of the material.

In the conventional art, the material has been selected in order to realize satisfactory wavelength dispersion, and consequently characteristics other than wavelength dispersion (characteristics such as photoelastic coefficient and glass transition temperature) have been also determined by the material. In contrast thereto, since the present invention is designed as described above, it is possible to select desired characteristics other than wavelength dispersion, without being influenced by the factor of wavelength dispersion. That is, the options of the material are broadened. For example, it is possible to realize desired wavelength dispersion of retardation while using a material with small photoelastic coefficient and a material with glass transition temperature (Tg) of 130°C or more.

(Principle for synthesis of retardation)

The following explains relations between (i) retardations of individual unit areas and wavelength dispersions thereof and (ii) retardation of a whole area and wavelength dispersion thereof. The explanation will allow clear understanding of why wavelength dispersions of retardations of individual unit areas are different from wavelength dispersion of retardation of a whole area, and why appropriately setting retardations and area ratios of individual unit areas allows controlling wavelength dispersion of retardation of the whole area.

Initially, as an example, the following explains what retardation will be obtained when macroscopically seeing a whole film in which unit areas with retardation of 100nm with respect to light of 450nm in wavelength and unit areas with retardation of 200nm with respect to light of 450nm in wavelength are provided alternately on a film plane in a striped manner. An area ratio of the unit area with retardation of 100nm to the unit area with retardation of 200nm is 1: 1.

A retardation film is disposed between two polarization plates whose polarization axes are parallel to each other in such a manner that a slow axis of the retardation film is rotated by 45° with respect to the polarization axes of the polarization plates. Fig. 2 is a graph showing a theoretical value of a ratio (transmittance) of light which has been linearly polarized light passing through one of the polarization plates and which also passes through the retardation film and the other of the polarization plates. A relation between transmittance and retardation is indicated by trigonometric function in theory, as shown in Fig. 2. The trigonometric function is represented by

$$I(\lambda) = 1/2 + 1/2 \cdot \cos(2\pi r_e/\lambda) \qquad \dots \text{ equation (b)}$$

where $I(\lambda)$ is transmittance with respect to light of wavelength $\lambda$ and $r_e$ is retardation with respect to light of $\lambda$ in wavelength.

In a case where retardation is 0, linearly polarized light having been converted by one polarization plate is incident to the other polarization plate without being subjected to birefringence by the retardation film. Transmittance in this case is set to 1 as shown in Fig. 2.

On the other hand, in a case where retardation with respect to wavelength $\lambda$ is $\lambda/2$ (i.e., retardation of 225nm with respect to light of 450nm in wavelength and retardation of 295nm with respect to light of 590nm in wavelength), the retardation film serves as a $\lambda/2$ retardation film. That is, the linearly polarized light is converted into linearly polarized light with its polarization axis rotated by 90°. Consequently, transmittance gets 0.

Fig. 3 is a graph showing an enlarged portion where retardation ranges from 100 to 200 nm. In the unit area with retardation of 100 nm with respect to light of 450 nm in wavelength, transmittance of the light of 450 nm in wavelength is 0.586. On the other hand, in the unit area with retardation of 200 nm with respect to light of 450 nm in wavelength, transmittance of the light of 450 nm in wavelength is 0.030. Since the area ratio of the unit area with retardation of 100nm to the unit area with retardation of 200nm is 1: 1, transmittance of the two areas as a whole is (0.586+0.030)/2=0.308. Here, it is known from Fig. 2 that retardation at which transmittance of light of 450 nm in wavelength is 0.308 is approximately 140 nm. Accordingly, a whole area in which the unit areas with retardation of 100nm and the unit areas with retardation of 200nm coexist with an area ratio of 1: 1 serves as a retardation film with retardation of 140nm. In this manner, retardation obtained when macroscopically seeing a whole area including unit areas is regarded as synthetic retardation.

It should be noted that the synthetic retardation here is not 150nm that is an intermediate value between 100nm and 200nm. The reason is as follows. Retardation of 100nm with respect to light of 450nm in wavelength is close to 1/4 of the wavelength, and retardation of 200nm with respect to light of 450nm in wavelength is close to 1/2 of the wavelength. Consequently, in a range of retardation from 100 to 200nm with respect to light of 450nm in wavelength, based on the equation (b) indicative of the relation between transmittance and retardation, a graph indicative of the relation between transmittance and retardation forms a downwardly convex shape. Consequently, synthetic optimal retardation shifts from 150nm to retardation close to 100nm (specifically 140nm).

Further, if wavelength dispersions of retardations r of individual unit areas meet a condition that r(590)=r(450) (r($\lambda$) indicates retardation with respect to light of $\lambda$ in wavelength), then synthetic retardation with respect to light of 590nm in wavelength is 150nm.

As described above, even if wavelength dispersions of retardations r of individual unit areas meet a condition that r(590)=r(450), wavelength dispersion of synthetic retardation R of a whole area is R(450)<R(590), and therefore the synthetic retardation R is different from the wavelength dispersions of individual unit areas.

This is because the cycle of the trigonometric function representing the relation between transmittance and retardation varies depending on wavelength of light.

As described above, by providing a plurality of unit areas with different retardations with respect to the same wavelength in a direction parallel to a light-incident plane, it is possible to make wavelength dispersion of synthetic retardation of a whole area differ from wavelength dispersions of retardations of individual unit areas. The wavelength dispersion of synthetic retardation of a whole area can be set by appropriately selecting retardations and wavelength dispersions of unit areas.

It should be noted that a cycle in which plural kinds of unit areas (two kinds of unit areas A and B in the drawing) are provided in plural times is repeated along a film plane as shown in Figs. 19 and 20, synthetic retardation of one cycle is equal to synthetic retardation of a whole area.

The above explanation was made as to a case where an area with retardation of 100nm with respect to light of 450nm and 590nm in wavelength and an area with retardation of 200nm with respect to light of 450nm and 590nm in wavelength coexist with an area ratio of 1: 1. However, retardation and an area ratio of individual unit areas may be appropriately selected according to wavelength dispersion of desired retardation of a whole area. Further, the above explanation was made as to a case where a parameter for birefringence is transmittance. Alternatively, a parameter other than transmittance may be used as long as the parameter indicates birefringence.

That is, when N (N is an integer of two or more) unit areas including a first area to an N$^{th}$ area with different retardations with respect to the same wavelength are dispersed in a direction parallel to a light-incident plane, wavelength of light in a visible light region is regarded as λ, retardation of an n$^{th}$ area (n is any integer of 1 to N) with respect to light of λ in wavelength is regarded as r(n, λ), an area ratio of the n$^{th}$ area to a whole area is regarded as M(n), and a feature value (such as the transmittance) indicative of birefringence of the n$^{th}$ area with respect to light of λ in wavelength is T(n, λ), retardation R(λ) that exhibits birefringence whose feature value is represented by

$$\sum_{n=1}^{N}\left[M(n)\times T(n,\lambda)\right]$$

with respect to light of λ in wavelength is synthetic retardation of the whole area with respect to the wavelength of λ.

In a case where reverse wavelength dispersion is desired, retardations of unit areas, wavelength dispersions of the retardations, and area ratios of the unit areas should be selected so that synthetic retardation R meets R(λ1)<R(λ2) and λ1<λ2.

On the other hand, in a case where normal wavelength dispersion is desired, retardations of unit areas, wavelength dispersions of the retardations, and area ratios of the unit areas should be selected so that synthetic retardation R meets R(λ1)>R(λ2) and λ1<λ2.

An area with retardation of 0, i.e., an area with no birefringence (for example, an area constituted only by air) may be included as one of unit areas.

(Result of simulation of synthetic retardation)

Based on the above principle, a simulation of synthetic retardation of a whole area of a retardation film in which unit areas with different retardations coexist along a light-incident plane was carried out.

Fig. 4 is a drawing showing the result of simulation of synthetic retardation of a whole area in Example 1 of a retardation film made of polycarbonate, in which a unit area with retardation of 275nm with respect to wavelength of 550nm and a unit area with retardation of 137.5nm with respect to wavelength of 550nm coexist with an area ratio of 1: 1. In Fig. 4, a broken line indicates wavelength dispersion of retardation in Comparative Example using a retardation film made of polycarbonate in which retardation is even along a light-incident plane.

As shown in Fig. 4, Comparative Example in which retardation is even along the light-incident plane shows normal wavelength dispersion (retardation gets larger as measured wavelength gets smaller). This is because of wavelength dispersion of birefringence of polycarbonate used as a material. In contrast thereto, Example 1 in which unit areas with different retardations coexist shows reverse wavelength dispersion. As described above, it was confirmed from the simulation that the retardation film of the present Embodiment shows wavelength dispersion different from wavelength dispersion of birefringence of the material of the retardation film.

That is, it was confirmed that the retardation film of the present Embodiment meets R(447) < R(548) < R(628).

Further, wavelength dispersion of a unit area is in accordance with wavelength dispersion of polycarbonate. That is, the unit area shows normal wavelength dispersion. Therefore, wavelength dispersion (wavelength dependence) of synthetic retardation R(λ) of a whole area and wavelength dispersion of retardation r(n, λ) of the unit area meet equation (c) below.

$$R(548) - R(447) > r(n, 548) - r(n, 447) \quad \ldots \text{equation (c)}$$

Further, it can be seen from Fig. 4 that equation (d) below is met.

$$R(628) - R(548) > r(n, 628) - r(n, 548) \quad \ldots \text{equation (d)}$$

As described above, even when the unit area shows normal wavelength dispersion, it is possible to design synthetic retardation of a whole area so that the synthetic retardation shows reverse wavelength dispersion.

Fig. 5 is a graph showing wavelength dispersion of synthetic retardation in a case where polycarbonate is used as the material and retardations and area ratios of individual unit areas are changed so that synthetic retardation of a whole area at wavelength of 550nm is 137.5nm. In the graph, the synthetic retardation at the longitudinal axis is normalized by retardation with respect to light of 550nm in wavelength.

The graph shows Example 2 in which unit areas with retardation of 300nm and 100nm with respect to light of 550nm in wavelength are mixedly provided with an area ratio of 0.433: 1, Example 3 in which unit areas with retardation of 220nm and 100nm with respect to light of 550nm in wavelength are mixedly provided with an area ratio of 0.513: 1, and Example 4 in which unit areas with retardation of 220nm and 50nm with respect to light of 550nm in wavelength are mixedly provided with an area ratio of 1.04: 1. It is seen from the graph that as a difference in retardation between unit areas gets larger, the degree of reverse wavelength dispersion of synthetic retardation R gets larger, i.e., R(590)/R(450) gets larger.

In Example 3, it was confirmed that R(548)=R(628). Further, it is possible to realize a relation R(447)=R(548) by making a difference in retardation between unit areas smaller than that of Example 3.

As described above, it was confirmed that by appropriately selecting retardations and area ratios of unit areas, it is possible to easily produce a retardation film having desired wavelength dispersion as a whole area.

Next, a simulation for detecting how wavelength dispersion of retardation of a whole area changes when a difference in retardation between adjacent unit areas are changed was carried out.

There was carried out a simulation of synthetic retardation of a whole area in a retardation film in which a first unit area with retardation of 220nm at wavelength of 550nm and a second unit area were disposed alternately in a striped manner so that an area ratio of the first unit area to the second unit area was 1: 1. Six kinds of retardations: 0, 50, 100, 150, 200, and 220 nm were used as retardation of the second unit area. The simulation was carried out under a condition that r2=220 nm and R(450)/R(590)=1.

Table 1 shows the result of the simulation. In Table 1, r1 indicates retardation of the first unit area, r2 indicates retardation of the second unit area, and Δr indicates (r1-r2)/r1×100.

[Table 1]

| r2 (nm) | r1-r2 (nm) | Δr (%) | R (550) (nm) | R(450)/R(590) |
|---------|-----------|--------|--------------|---------------|
| 0 | 220 | 100 | 133.2489 | 0.84363 |
| 50 | 170 | 77 | 139.7951 | 0.864189 |
| 100 | 120 | 55 | 157.5233 | 0.90723 |
| 150 | 70 | 32 | 182.295 | 0.949594 |
| 200 | 20 | 9 | 209.5831 | 0.987737 |
| 220 | 0 | 0 | 220 | 1 |

Further, Fig. 25 is a drawing showing a relation between Δr and R(450)/R(590).

There was carried out a simulation of synthetic retardation of a whole area in a retardation film in which a first unit area with retardation of 220nm at wavelength of 550nm and a second unit area were disposed alternately in a striped manner so that an area ratio of the first unit area to the second unit area was 0.513: 1. Six kinds of retardations: 0, 50, 100, 150, 200, and 220 nm were used as retardation of the second unit area. The simulation was carried out using polycarbonate under a condition that r2=220 nm and R(450)/R(590)=1.066482.

Table 2 shows the result of the simulation.

[Table 2]

| r2 (nm) | r1-r2 (nm) | Δr (%) | R (550) (nm) | R(450) / R(590) |
|---------|-----------|--------|--------------|-----------------|
| 0 | 220 | 100 | 102.7505 | 0.864209 |
| 50 | 170 | 77 | 112.502 | 0.904098 |
| 100 | 120 | 55 | 137.4775 | 0.967279 |
| 150 | 70 | 32 | 170.5229 | 1.011326 |
| 200 | 20 | 9 | 206.2528 | 1.037355 |

(continued)

| r2 (nm) | r1-r2 (nm) | $\Delta$r (%) | R (550) (nm) | R(450) / R(590) |
|---------|-----------|---------------|--------------|-----------------|
| 220 | 0 | 0 | 220 | 1.066482 |

Further, Fig. 26 is a drawing showing a relation between $\Delta$r and R(450)/R(590).

As shown in Tables 1 and 2 and Figs. 25 and 26, as a difference in retardation between adjacent unit areas becomes larger, differences in retardation and in wavelength dispersion of the retardation between a unit area and a whole area becomes larger. Therefore, if it is requested that retardation of the whole area and wavelength dispersion thereof are greatly different from retardation of a material used for the unit area and wavelength dispersion thereof, it is desirable that the difference in retardation between adjacent unit areas is made larger (specifically, made equal to or more than 100nm).

(Example of measurement of synthetic retardation)

Next, validities of the aforementioned principle and the results of the simulations were examined by measuring retardation of an optical element. Automatic birefringence analyzer KOBRA-WR manufactured by Oji Scientific Instruments was used as a device for measuring retardation.

Fig. 6 shows the result of measurement of wavelength dispersion of retardation in a retardation film made of polycarbonate with even thickness, i.e. a retardation film in which retardation is even in a direction parallel to a film plane (measured spot was 5.8mm square). As shown in Fig. 6, in a case where the retardation is even in a direction parallel to a film plane, the retardation film exhibits normal wavelength dispersion. This is due to wavelength dispersion of birefringence of polycarbonate used as a material.

On the other hand, there was prepared a retardation film obtained by putting, on a $\lambda$/4 retardation film (film with retardation of 137.5nm with respect to light of 550nm in wavelength) made of the same polycarbonate and having an even thickness, the same $\lambda$/4 retardation films each having a width of 1mm and having a strip shape in such a manner that adjacent two of the same $\lambda$/4 retardation films have a distance of 1mm. That is, the retardation film is designed such that a rectangular unit area with retardation of 137.5nm with respect to light of 550nm in wavelength and a rectangular unit area with retardation of 275nm with respect to light of 550nm in wavelength were disposed in a striped manner with a distance of 1mm between adjacent unit areas of the same kind.

Wavelength dispersion of retardation of the retardation film was measured with a measured spot of 5.8mm square. Since the measured spot is 5.8mm square, there was observed synthetic retardation when macroscopically observing an area in which a unit area with retardation of 137.5nm and a unit area with retardation of 275nm coexist.

That is, the measured spot includes approximately 2.9 cycles each including a unit area with retardation of 137.5nm and a unit area with retardation of 275nm in a short side direction of the unit area. Therefore, this measurement is equal to measurement of wavelength dispersion of synthetic retardation R($\lambda$) when light flux passes through the retardation film at a spot including at least one cycle.

Fig. 7 is a graph showing the result of measurement of wavelength dispersion of retardation of a retardation film in which an area with retardation of 137.5nm and an area with retardation of 275nm each with respect to light of 550nm in wavelength are provided in a striped manner with a distance of 5mm between adjacent areas of the same kind. In Fig. 7, the measured wavelength is normalized by wavelength of 550nm. As shown in Fig. 7, synthetic retardation shows reverse wavelength dispersion in which retardation gets smaller as the measured wavelength gets smaller.

On the other hand, retardation of polycarbonate shows normal wavelength dispersion. This confirmed that wavelength dispersion of synthetic retardation obtained when light flux passed through a spot of a retardation film was substantially different from wavelength dispersion of retardation of light flux passing through individual unit areas.

Next, comparison of a measured value and the result of the simulation was carried out. Fig. 8 is a graph showing a comparison of a measured value of synthetic retardation of a retardation film made of polycarbonate in which unit areas with retardations of 313nm and 140nm with respect to light of 550nm in wavelength were provided mixedly with an area ratio of 0.5: 1 and the result of simulation (shown as calculated value in the drawing). In the drawing, the measured value of the synthetic retardation is normalized by synthetic retardation (163nm) with respect to light of 550nm in wavelength. As shown in the drawing, wavelength dispersion of the synthetic retardation was substantially identical with the result of the simulation. This confirmed that the aforementioned principle and the result of the simulation are valid.

(Method for mixedly providing areas with different retardations)

The following explains a specific example of a method for providing a plurality of unit areas with different retardations with respect to light of the same wavelength along with a light-incident plane.

Retardation Re is represented by a product of birefringence (An) of a film and a thickness (d), i.e. Re=$\Delta n \times d$.

Therefore, by making at least one of birefringence ($\Delta n$) and a thickness (d) differ, it is possible to mixedly provide unit areas with different retardations.

Figs. 9, 10, 11, and 12 show examples of the retardation film 1 in each of which a thickness of the film is changed so as to mixedly provide unit areas 2 with different retardations. In the drawings, (a) shows a perspective drawing and (b) shows a cross sectional drawing.

As shown in Fig. 9, the retardation film 1 may be designed such that the unit areas 2 with different thickness are provided alternately in a striped manner. As shown in (b) of Fig. 9, the thickness of the unit area 2 is even throughout the whole portions of the unit area 2.

Fig. 10 shows an example of the retardation film 1 in which protrusions 5 each having a triangular cross section are formed on a plane of a flat film 4 with a predetermined distance therebetween. In this case, the retardation film 1 is divided into a unit area 2 (region indicated by 2-2 in the drawing) where the protrusion 5 is not formed and a unit area 2 (region indicated by 2-1, 2-3 in the drawing) where the protrusion 5 is formed.

Fig. 11 shows an example of the retardation film 1 in which a cross section of one plane of the film has a sawtooth shape. In this case, the retardation film 1 is divided into a unit area 2 having a point of the maximum thickness at its center and having a width of 1/2 of a cycle of the sawtooth (region indicated by 2-1, 2-3 in the drawing) and a unit area 2 having a point of the minimum thickness at its center and having a width of 1/2 of a cycle of the sawtooth (region indicated by 2-2 in the drawing).

Fig. 12 shows an example of the retardation film 1 in which protrusions 6 each having a projectile shape are formed on a plane of a flat film 4 with a predetermined distance therebetween. In this case, the retardation film 1 is divided into a unit area 2 (area indicated by 2-2 in the drawing) where the protrusion 6 is not formed and a unit area 2 (area indicated by 2-1, 2-3 in the drawing) where the protrusion 6 is formed.

It should be noted that when the retardation film 1 is divided into a plurality of unit areas 2 along the light-incident plane as above, a difference in retardation between adjacent two unit areas is required to be 10nm or more. This enlarges a difference in retardation between the unit areas 2, making it easier to design the film so that wavelength dispersion of synthetic retardation of a whole region has a desired value.

In a case where retardation changes continuously as in the unit areas 2-1 and 2-3 of Fig. 10, in the unit area 2-n (n=1, 2, ...) of Fig. 11, and in the unit areas 2-1 and 2-3 of Fig. 12, retardation of the unit area 2 is calculated similarly with the aforementioned principle. That is, the retardation of the unit area 2 is calculated in such a manner that an average $I_{ave}$ of transmittances derived from a change in retardation in the unit area 2 is calculated and retardation when transmittance is the average $I_{ave}$ is regarded as retardation of the unit area 2.

In a case of measuring retardation of a minute unit area, an automatic birefringence analyzer such as KOBRA-WR cannot measure the retardation since a spot measurable by the automatic birefringence analyzer is too large. Accordingly, a polarized microspectrophotometer is used in measurement. For example, by using a liquid crystal cell gap measuring device (TFM-120AFT) including a polarized microspectrophotometer, manufactured by ORC MANUFACTURING CO., LTD., it is possible to measure retardation of a minor area of approximately 10$\mu$m square.

Examples of a method for mixedly providing unit areas with different retardations by changing thickness of the unit areas include nanoimprint transfer, UV light roll transfer, screen printing, and ink-jet printing.

That is, by transferring a polymer material with a predetermined pattern on a film by nanoimprinting and then stretching the film, it is possible to produce a retardation film with different thickness.

Further, a metal mold may be pressed to a film so that a thickness of the film differs partially. Further, an energy ray such as laser light may be partially irradiated to a film so as to form a concave section, thereby making a thickness of the film differ.

Further, in a case where unit areas with different retardations are formed by changing a thickness of a film, it is desirable that concavities and convexities of a surface of the film due to the change in thickness are filled with a material with low retardation in which retardation is relatively low (ideally 0), i.e. a material that does not exhibit birefringence when seen from a direction perpendicular to a light-incident plane, a material such as acrylic resin curable by UV light and electron beam so as to make the surface of the retardation film evenly. This prevents light scattering.

Examples of the material with low retardation are unstretched polymers as follows: polycarbonate polymers produced by polycondensation of bisphenol A and carbonyl chloride; polyacrylic esters such as polyacrylic methyl and polymethacrylic methyl; polyester polymers obtained by condensation of diacid base such as adipic acid, phthalic acid, isophthalic acid, and terephthalic acid and glycol such as ethylene glycol, diethylene glycol, propylene glycol, tetramethylene glycol, and neopenthyl glycol or ring-opening polymerization of lactones; styrene polymers such as polystyrene and poly($\alpha$-methylstyrene); copolymers of acrylic ester and styrene; polyolefin polymers such as polyethylene, polypropylene, norbornene resin, cycloolefin polymer, hydrogen additive of polyisoprene, hydrogen additive of polybutadiene; cellulose resin such as triacetylcellulose and ethylcellulose; polyamide such as nylon 6 and nylon 66; polyimide; polyamideimide; polyvinylalcohol; polyvinylchloride; polysulfone; polyethersulfone; polyarylate; epoxy resin; silicone resin; compounds described in WO 01/37007 publication etc.

Alternatively, the retardation film may be arranged such that birefringence is different among areas while the thicknesses of the areas are the same as each other. In a case of a polymer film, birefringence is produced by stretching polymers constituting the film so that molecules of the polymers are orientated. Here, birefringence $\Delta n$ is represented by a product of intrinsic birefringence $\Delta n_0$ of polymers and a degree f of orientation, i.e. $\Delta n = f \times \Delta n_0$.

Accordingly, by partially stretching the polymer film as shown in Fig. 13, it is possible to produce areas with different degrees of orientation. Since the degrees of orientation of the areas are different, birefringences of the areas are different according to the above equation.

Alternatively, by heating a specific area of an evenly stretched polymer film, it is possible to make orientation of molecules of the specific area differ from other areas of the evenly stretched polymer film. An example of a method for heating is heating a plate having a predetermined pattern as a convex and causing only the convex to be in contact with a polymer film. For example, a thermal head is made to contact with a part of an evenly stretched film, and heat continues to be applied until orientation becomes a former state. This provides a heated unit area and an unheated unit area that are adjacent to each other, making a difference in retardation between the adjacent unit areas 10nm or more.

Alternatively, a material including a reactive cross-linking agent (jump agent) that cross-links in response to an energy ray such as laser light and UV light may be molded and stretched to have a film shape, and the film is partially subjected to irradiation of the energy ray. Consequently, only a portion subjected to irradiation of the energy ray has high molecular weight, making retardation differ between the portion subjected to the irradiation and a portion not subjected to the irradiation. Alternatively, a material that has low molecular weight in response to irradiation of UV light may be molded and stretched to have a film shape, and the film is partially subjected to irradiation of the UV light.

Alternatively, a film may be evenly stretched and partially subjected to ejection of a solvent by ink-jet so that the state of orientation becomes a state before the stretching of the film.

Alternatively, an orientation film may be partially formed on a substrate and a polymer material may be cast on the substrate. Consequently, retardation differs between a portion where the orientation film is formed and a portion where the orientation film is not formed.

Alternatively, block copolymers or graft copolymers described in Japanese Patent Application Publication, Tokukaisho, No. 61-146301 may be aligned so as to form microdomains.

Alternatively, unit areas with different retardations may be formed using phase separation in polymer blend. A specific example of this formation will be described later.

Disposition of unit areas with different retardations is not particularly limited. The disposition may be a stripe manner as shown in (b) of Fig. 1, may be a matrix manner as shown in Fig. 14, or may be any disposition.

Alternatively, a part may be removed from a polymer film with even retardation. In this case, air fills in the removed part, serving as an area with retardation of 0nm.

Examples of the material used for the optical element of the present Embodiment include: polycarbonate polymers produced by polycondensation of bisphenol A and carbonyl chloride; polyacrylic esters such as polyacrylic methyl and polymethacrylic methyl; polyester polymers obtained by condensation of diacid base such as adipic acid, phthalic acid, isophthalic acid, and terephthalic acid and glycol such as ethylene glycol, diethylene glycol, propylene glycol, tetramethylene glycol, and neopenthyl glycol or ring-opening polymerization of lactones; styrene polymers such as polystyrene and poly($\alpha$-methylstyrene); copolymers of acrylic ester and styrene; polyolefin polymers such as polyethylene, polypropylene, norbornene resin, cycloolefin polymer, hydrogen additive of polyisoprene, hydrogen additive of polybutadiene; cellulose resin such as triacetylcellulose and ethylcellulose; polyamide such as nylon 6 and nylon 66; polyimide; polyamideimide; polyvinylalcohol; polyvinylchloride; polysulfone; polyethersulfone; polyarylate; epoxy resin; silicone resin; compounds described in WO 01/37007 publication etc.

The optical element of the present invention is not necessarily made of a single material. For example, as shown in Fig. 9, the optical element may be configured such that on a first film with even retardation, an area with another retardation made of a second material is formed in a striped manner.

The material for realizing retardation may preferably be a liquid crystal material and an inorganic material in addition to the polymer material. Examples of the inorganic material are, as described in Japanese Patent Application Tokukaihei, No. 7-43707 and Patent No. 2751140, oxides such as tantalum oxide, tin oxide, cerium oxide, zirconium oxide, bismuth oxide, titanium oxide, silicon oxide, and molybdenum oxide. By obliquely depositing these oxides on a substrate, it is possible to form a retardation layer. If these liquid crystal materials and/or the inorganic materials are used, it is possible to form a pattern with desired retardation by etching in combination with publicly known photoresist as shown in Figs. 15(a) and 15(b).


(Example of producing retardation film by phase separation)


As an example of a method for mixedly providing unit areas with different birefringence, a method using phase separation in polymer blend was mentioned above. The following specifically explains an example of this method.

Initially, 30g of methylene chloride was added to 7.5g of commercially available polycarbonate (glass transition temperature: 150°C), and dissolved at 25°C. Further, 38.5g of methylene chloride was added to 6.8g of cycloolefin polymer (glass transition temperature: 170°C) and dissolved at 25°C. Then, these solutions were mixed and stirred sufficiently, and then cast on a polyethylene naphthalate film. Thereafter, the resultant was dried at 25°C for 15 hours in the air, and then the cast film was peeled off from the polyethylene naphthalate film, and then dried at 60°C for 30 minutes, at 100°C for 30 minutes, and at 130°C for 30 minutes in the air. Then, the resultant was uniaxially stretched by 1.15 times at 165°C to obtain a stretched film of 35μm in thickness.

Fig. 21 shows a photograph of the stretched film captured by a microscope under parallel Nicols. It is seen from Fig. 21 that the two kinds of polymers were phase-separated, and different retardations appeared due to a difference in orientation birefringence between the two kinds of polymers (a portion with a thicker color has higher retardation than a surrounding portion). On the other hand, using an automatic birefringence analyzer KOBRA-WR (spot: 5.8mm square) manufactured by Oji Scientific Instruments, retardation on a plane of the stretched film was measured with respect to light of 447nm, 501nm, 548nm, 586nm, 628nm, and 748nm in wavelength at 25°C. The spot included a plurality of unit areas of respective polymers that were phase-separated. Consequently, retardation measured by KOBRA-WR was equal to synthetic retardation of a whole area. Retardations with respect to light of individual wavelengths were 129nm, 139nm, 143nm, 145nm, 148nm, and 151nm, respectively. Fig. 22 shows the result of measurement of normalized synthetic retardation (synthetic retardation with respect to light of 550nm in wavelength was regarded as 1) of a blend cast film of polycarbonate/cycloolefin polymer.

For comparison, a film was prepared in the same manner as above except that a methylene chloride solution of cycloolefin polymer was not used. This film was a polycarbonate cast film. Fig. 23 shows the result of measurement of normalized retardation (retardation with respect to light of 550nm in wavelength was regarded as 1) of the polycarbonate cast film under the same measurement conditions as those of Fig. 22. Further, a film was prepared in the same manner as above except that a methylene chloride solution of polycarbonate was not used. This film was a cycloolefin polymer cast film. Fig. 24 shows the result of measurement of normalized retardation (retardation with respect to light of 550nm in wavelength was regarded as 1) of the cycloolefin polymer cast film under the same measurement conditions as those of Fig. 22.

It was confirmed from Figs. 22-24 that synthetic retardation of the blend cast film of the polycarbonate/cycloolefin polymer shows wavelength dispersion that is inverse to wavelength dispersions of retardations of the polycarbonate and the cycloolefin polymer.

(Viewing angle characteristic)

Subsequently, viewing angle characteristic of the retardation film of the present Embodiment was examined.

In a configuration in which a backlight, a polarization plate, the retardation film of the present Embodiment, and a polarization plate were disposed in this order (two polarization plates were disposed so that polarization axes thereof were perpendicular to each other), viewing angle characteristic of luminance at the retardation film side was simulated. An angle formed by a slow axis of the retardation film and the polarization axis of the polarization plate was set to 45°.

The simulation was carried out using the retardation films in Examples 2, 3, and 4 explained above. Further, the simulation was carried out using Comparative Example that is a retardation film in which retardation with respect to light of 550nm in wavelength was 137.5nm and retardation was even along a light-incident plane. The material of all the films was polycarbonate.

Fig. 16 shows the result of simulation of viewing angle characteristic of luminance. (a) of Fig. 16 shows Comparative Example, (b) of Fig. 16 shows Example 3 (retardation of 220nm and retardation of 100nm coexist), (c) of Fig. 16 shows Example 4 (retardation of 220nm and retardation of 50nm coexist), and (d) of Fig. 16 shows Example 2 (retardation of 300nm and retardation of 100nm coexist). It is seen from Fig. 16 that Examples show higher viewing angle characteristic than Comparative Example. Further, it is seen from Fig. 16 that as a difference in retardation between unit areas is larger, viewing angle characteristic is better.

The result of simulation in Example 2 resembles the result of simulation using a retardation film in which Nz coefficient that is an index of viewing angle characteristic is 0.5. Therefore, it is considered that as the retardation film of the present Embodiment has Nz coefficient close to 0.5, the retardation film has better viewing angle characteristic.

Nz coefficient is represented by $Nz = (nx - nz) / (nx - ny)$ where nx, ny, and nz represent refractive indices of x-axis direction, y-axis direction, and z-axis direction, respectively, where x-axis is a direction in which the maximum refractive index is appears on a film plane, y-axis is a direction perpendicular to x-axis on the film plane, and z-axis is a film thickness direction.

In order to examine validity of the result of this simulation, retardation of a retardation film of Example 5 in which a unit area with retardation of 313nm and a unit area with retardation of 140nm with respect to light of 550nm in wavelength were provided with an area ratio of 0.5: 1 was measured while changing an angle with respect to a light-incident plane. Fig. 17 is a graph showing the result of viewing angle characteristic of retardation. In the drawing, the longitudinal axis indicates a value obtained by normalizing the retardation of the retardation film by retardation at incident angle 0° being 1. The lateral axis indicates an angle with respect to an axis perpendicular to the light-incident plane (incident angle). In Fig. 17, for reference, a measured value of the Comparative Example (Comparative Example in which retardation was even in a film plane direction (material: polycarbonate)) and the result of the simulation of Example 5 (the result is described as calculated value in the drawing) are shown.

It is seen from Fig. 17 that Example 5 shows better viewing angle characteristic than the Comparative Example. Further, since measured values resemble simulated values, it is confirmed that the result of the simulation is valid.

As described above, the retardation film of the present Embodiment yields an effect of improving viewing angle characteristic.

(Application Example)

The retardation film of the present Embodiment is applicable to display devices such as liquid crystal displays and EL displays.

With the retardation film of the present Embodiment, by suitably selecting retardations and area ratios of unit areas, it is possible to cause synthetic retardation of a whole area to have reverse wavelength dispersion. This allows realizing a retardation film that exhibits reverse wavelength dispersion which is more inclined than wavelength dispersion controlled by a material. Therefore, the retardation film of the present Embodiment is useful for the purpose of preventing reflection in EL displays and liquid crystal displays.

Further, in a case of optically compensating birefringence of liquid crystal molecules, a retardation film exhibiting the same wavelength dispersion as that of birefringence of the liquid crystal molecules is desirable. With the retardation film of the present Embodiment, by suitably selecting retardations and area ratios of unit areas, it is possible to cause synthetic retardation of a whole area to correspond to wavelength dispersion of the liquid crystal molecules. Consequently, the retardation film can be used for optically compensating birefringence of the liquid crystal molecules.

Fig. 27 is a drawing showing one example of a liquid crystal display device including the retardation film 1 of the present Embodiment.

As shown in the drawing, the liquid crystal display device 10 includes a backlight device including a light source 11, a light guide plate 12, a light diffusing plate 13, and a prism sheet 14. Further, the liquid crystal display device 10 includes, at a side of the backlight device closer to a viewer, a display panel in which a luminance increasing film 15, a polarization plate 16, a glass 17, a liquid crystal layer 18, a color filter 19, a glass 20, the retardation film 1 of the present Embodiment, a polarization plate 21, a surface reflection preventing layer 22 are laminated in this order. The position of the retardation film 1 is not limited to the position in Fig. 27. The retardation film 1 may be positioned at a side of the liquid crystal layer 18 closer to a viewer or at an opposite side.

The liquid crystal display device 10 has a display mode such as TN mode, VA mode, and IPS mode.

The liquid crystal display device 10 should be designed to select the retardation film 1 having synthetic retardation suitable for wavelength dispersion of birefringence of liquid crystal molecules constituting a liquid crystal layer. As described above, the retardation film of the present Embodiment allows designing wavelength dispersion of synthetic retardation comparatively freely regardless of properties of the material for the retardation film.

In a case where a retardation film is used for optically compensating the liquid crystal display device 10 with high image quality and based on display mode such as TN mode, VA mode, IPS mode, and OCB mode, required retardation is generally 350nm or less (see Japanese Patent Application Publication Tokukaihei, No. 4-305602). Therefore, synthetic retardation R(550) is preferably 350nm or less.

Further, since it was confirmed that the retardation film of the present Embodiment has excellent viewing angle characteristic, the retardation film can be used as a retardation film for compensating viewing angle characteristic of a polarization plate. Consequently, it is possible to provide an optical device including polarization plates and the retardation film of the present Embodiment to which polarized light having passed through one of the polarization plates is incident. The optical device is suitable for improving viewing angle characteristic, and is applicable to a liquid crystal display device etc.

As described above, in the retardation film of the present Embodiment, the size of a unit area is set according to circumstances in which a display device including the retardation film is used.

For example, in a case of a display device such as a liquid crystal display provided in a room in a house, that is, in a case of a display device supposed to be seen within a range of several meters, the size of a unit area is $50\mu m$ or less, preferably $10\mu m$ or less. A difference in retardation between adjacent two unit areas is preferably 10nm or more as described above.

As shown in Fig. 27 for example, the display device of the present Embodiment includes a polarization plate, the retardation film of the present Embodiment, and a member in which a plurality of display cells are arrayed (member such as a liquid crystal layer 18 and a color filter 19 sandwiched between a pair of substrates) in this order. The display cell is a region with the minimum display unit (dot). For example, in a case where one liquid crystal cell is overlapped by one of the color filters 19 corresponding to three primary colors (RGB) and three colored liquid crystal cells constitute one pixel, individual R, G, and B liquid crystal cells that are sub pixels constituting the pixel are referred to as display cells. In this case, the retardation film should be designed such that a region facing each display cell includes a plurality of unit areas. This designing allows the retardation film to exhibit, with respect to each display cell, wavelength dispersion of synthetic retardation obtained by synthesizing retardations of the plurality of unit areas facing the display cell. That is, the display device uses, in each display cell, wavelength dependence of synthetic retardation of the retardation film.

In a case where the retardation film is designed such that a region facing each display cell includes a plurality of unit areas even when a relative positional relationship between the retardation film and the liquid crystal layer is changed, it is unnecessary to control position of the retardation film when fabricating the display device. That is, it is possible to provide the retardation film independently of other optical elements such as a color filter, without considering relative positional relationship with the other optical elements.

In a case where a borderline of a display cell corresponds to a borderline of a unit area, there is a possibility that interference occurs. Accordingly, it is preferable that a borderline of a display cell does not correspond to a borderline of a unit area. For example, in a case where a plurality of unit areas with different retardations are positioned in a certain cycle, the cycle should be set so that an integral multiple of the cycle does not equal to the width of a unit area. Alternatively, in a case of using a retardation film in which rectangular unit areas with different retardations are provided in a striped manner as shown in (b) of Fig. 1, a long side of each unit area may be disposed obliquely with respect to borderlines corresponding to RGB of the color filter 19 (i.e. borderlines of display cells). Providing borderlines of the unit areas obliquely with respect to borderlines of the display cells in this manner resolve the problem of the interference.

The display cell may be a liquid crystal display cell constituted by a liquid crystal material as in the above examples, or may be an EL display cell.

The invention being thus described, it will be obvious that the same way may be varied in many ways. Such variations are not to be regarded as a departure from the scope of the invention, and all such modifications as would be obvious to one skilled in the art are intended to be included within the scope of the following claims.

Industrial Applicability

The optical element of the present invention is usable as a retardation film for a display device such as a liquid crystal display and an EL display.

**Claims**

1. A display device being one of a liquid crystal display and an electro luminescence (EL) display, the display device including an optical element (1), including a plurality of unit areas (2) in a direction parallel to a light-incident plane of the optical element, the unit areas including a plurality of unit areas (2-1, 2-2, ... 2-N) whose retardation with respect to light of a certain wavelength is different by 10nm or more from retardation of adjacent unit areas with respect to light of the certain wavelength,
   wherein:

   at least a polarization plate, the optical element (1), and a member in which a plurality of display cells that are a minimum display unit are arrayed are provided in this order;
   a difference in wavelength dependence exists between retardation $r(n, \lambda)$ of each of the unit areas and synthetic retardation $R(\lambda)$ of a whole area (3) including all of the unit areas (2-1, 2-2, ... 2-N), where $r(n, \lambda)$ indicates retardation of an $n^{th}$ unit area with respect to light of $\lambda$nm in wavelength, $R(\lambda)$ is synthetic retardation with respect to light of $\lambda$nm in wavelength, and wherein the synthetic retardation $R(\lambda)$ of the whole area corresponds to the retardation obtained when the whole area is macroscopically seen;
   the display device being **characterized in that**
   the optical element includes, in a region facing each of the display cells that are a minimum display unit, a plural number of unit areas out of the unit areas.

2. The display device as set forth in claim 1, wherein:

   the optical element has a form of a plane so as to cause even retardation in the plane,
   the optical element is designed such that the plane is a light-incident plane, and in at least one direction on the plane, there are repeated cycles each successively having a plurality of unit areas with at least one of birefringence and a thickness being different among the unit areas, at least one of the unit areas being a birefringent area.

3. The display device as set forth in claim 2, wherein:

the display device is a liquid crystal display device;

the optical element is used as retardation plate provided at a viewer side or opposite side of a liquid crystal layer (18) of the liquid crystal display device (10); and

one or more of the cycles correspond to each of the display cells of the liquid crystal display device.

4. The display device as set forth in any one of claims 1 to 3, wherein
in a case where the optical element is positioned between a pair of polarization plates whose polarization directions are parallel to each other in such a manner that a slow axis of the optical element is rotated by 45° from the polarization directions of the polarization plates, if transmittance when linearly polarized light of $\lambda$ in wavelength from one of the polarization plates passes through an $n^{th}$ unit area and the other of the polarization plates is I(n, $\lambda$) and an area ratio of the $n^{th}$ unit area to the whole area in terms of the light-incident plane is M(n), the synthetic retardation R($\lambda$) is retardation that exhibits transmittance represented by

$$\sum_{n=1}^{N}\left[M(n)\times I(n,\lambda\,\right]$$

with respect to light of $\lambda$ in wavelength.

5. The display device as set forth in any one of claims 1 to 4, wherein the wavelength dependence of the synthetic retardation R($\lambda$) meets equation (1):

$$R(447) \leq R(548) \leq R(628) \qquad \ldots \text{equation (1)}$$

6. The display device as set forth in any one of claims 1 to 5, wherein the wavelength dependence of the synthetic retardation R($\lambda$) and the wavelength dependence of retardation r(n, $\lambda$) of at least one of the unit areas meet equation (2):

$$R(548) - R(447) > r(n, 548) - r(n, 447) \qquad \ldots \text{equation (2)}$$

7. The display device as set forth in any one of claims 1 to 6, wherein the wavelength dependence of the synthetic retardation R($\lambda$) and the wavelength dependence of retardation r(n, $\lambda$) of at least one of the unit areas meet equation (3):

$$R(628) - R(548) > r(n, 628) - r(n, 548) \qquad \ldots \text{equation (3)}$$

8. The display device as set forth in claim 6, wherein relations R(548) - R(447) > 0 and r(n, 548) - r(n, 447) < 0 are met with respect to all n.

9. The display device as set forth in any one of claims 1 to 8, wherein each of retardations of the plurality of unit areas is substantially one of two different retardations.

10. The display device as set forth in any one of claims 1 to 9, wherein the optical element has a form of a film, a sheet, or a plate.

11. The display device as set forth in any one of claims 1 to 10, wherein the display cell is a liquid crystal display cell.

12. The display device as set forth in any one of claims 1 to 11, wherein the optical element is disposed between two polarization plates parallel to each other in order to improve viewing angle characteristic.

**13.** The display device as set forth in any one of clams 1 to 11, wherein polarized light having passed through the polarization plate is incident to the optical element.

**Patentansprüche**

**1.** Anzeigevorrichtung, die aus einer Flüssigkristallanzeige oder einer Elektrolumineszenz-(EL)-Anzeige besteht, wobei die Anzeigevorrichtung ein optisches Element (1) aufweist, das eine Vielzahl von Flächeneinheiten (2) in eine Richtung parallel zu einer Lichteinfallsebene des optischen Elements aufweist, wobei die Flächeneinheiten eine Vielzahl von Flächeneinheiten (2-1, 2-2, ... 2-N) aufweisen, deren Verzögerung bezüglich Licht einer bestimmten Wellenlänge sich um 10 nm oder mehr von einer Verzögerung benachbarter Flächeneinheiten bezüglich des Lichts der bestimmten Wellenlänge unterscheidet,
wobei:

mindestens eine Polarisationsplatte, das optische Element (1) und ein Element, in dem eine Vielzahl von Anzeigezellen angeordnet sind, die eine minimale Anzeigeeinheit sind, in dieser Reihenfolge vorgesehen sind;
ein Unterschied der Wellenlängenabhängigkeit zwischen der Verzögerung $r(n, \lambda)$ jeder der Flächeneinheiten und einer synthetischen Verzögerung $R(\lambda)$ einer Gesamtfläche (3) vorhanden ist, die alle Flächeneinheiten (2-1, 2-2, ... 2-N) umfasst, wobei $r(n, \lambda)$ die Verzögerung einer nten Flächeneinheit bezüglich Licht mit einer Wellenlänge von $\lambda$ nm anzeigt, $R(\lambda)$ die synthetische Verzögerung bezüglich Licht mit einer Wellenlänge von $\lambda$ nm ist, und wobei die synthetische Verzögerung $R(\lambda)$ der Gesamtfläche der Verzögerung entspricht, die erhalten wird, wenn die Gesamtfläche makroskopisch betrachtet wird;
wobei die Anzeigevorrichtung **dadurch gekennzeichnet ist, dass**
das optische Element in einem Bereich, der jeder der Anzeigezellen gegenüberliegt, die eine minimale Anzeigeeinheit sind, eine Mehrzahl von Flächeneinheiten aus den Flächeneinheiten umfasst.

**2.** Anzeigevorrichtung nach Anspruch 1, wobei:

das optische Element eine Form einer Ebene aufweist, um eine gleichmäßige Verzögerung in der Ebene zu bewirken,
das optische Element so gestaltet ist, dass die Ebene eine Lichteinfallsebene ist, und es in mindestens eine Richtung auf der Ebene wiederholte Zyklen gibt, die jeweils nacheinander eine Vielzahl von Flächeneinheiten mit einer Doppelbrechung und/oder einer Dicke aufweisen, die sich zwischen den Flächeneinheiten unterscheidet, wobei mindestens eine der Flächeneinheiten eine doppelbrechende Fläche ist.

**3.** Anzeigevorrichtung nach Anspruch 2, wobei:

die Anzeigevorrichtung eine Flüssigkristallanzeigevorrichtung ist;
das optische Element als eine Verzögerungsplatte verwendet wird, die auf einer Betrachtungsseite oder auf einer gegenüberliegenden Seite einer Flüssigkristallschicht (18) der Flüssigkristallanzeigevorrichtung (10) vorgesehen ist; und
einer oder mehrere der Zyklen jeder der Anzeigezellen der Flüssigkristallanzeigevorrichtung entsprechen.

**4.** Anzeigevorrichtung nach einem der Ansprüche 1 bis 3, wobei in einem Fall, in dem das optische Element zwischen einem Paar Polarisationsplatten angeordnet ist, deren Polarisationsrichtungen parallel zueinander sind, so dass eine langsame Achse des optischen Elements um 45° von den Polarisationsrichtungen der Polarisationsplatten gedreht wird, wenn der Transmissionsgrad, wenn linear polarisiertes Licht mit der Wellenlänge $\lambda$ von einer der Polarisationsplatten durch eine nte Flächeneinheit und die andere der Polarisationsplatten geht, $I(n, \lambda)$ ist, und ein Flächenverhältnis der nten Flächeneinheit zur Gesamtfläche bezüglich der Lichteinfallsebene $M(n)$ ist, die synthetische Verzögerung $R(\lambda)$ eine Verzögerung ist, die einen Transmissionsgrad aufweist, der durch

$$\sum_{n=1}^{N} [M(n) \times I(n, \lambda)]$$

bezüglich Licht mit der Wellenlänge $\lambda$ repräsentiert wird.

5. Anzeigevorrichtung nach einem der Ansprüche 1 bis 4, wobei die Wellenlängenabhängigkeit der synthetischen Verzögerung R($\lambda$) die Gleichung (1) erfüllt:

$$R(447) \leq R(548) \leq R(628) \ldots\ldots\ldots\ldots\ldots\ldots\ldots\ldots\ldots\ldots\ldots\ldots\text{Gleichung (1)}$$

6. Anzeigevorrichtung nach einem der Ansprüche 1 bis 5, wobei die Wellenlängenabhängigkeit der synthetischen Verzögerung R($\lambda$) und die Wellenlängenabhängigkeit der Verzögerung r(n, $\lambda$) von mindestens einer der Flächeneinheiten die Gleichung (2) erfüllen:

$$R(548) - R(447) > r(n, 548) - r(n, 447) \ldots\ldots\ldots\ldots\ldots\text{Gleichung (2)}$$

7. Anzeigevorrichtung nach einem der Ansprüche 1 bis 6, wobei die Wellenlängenabhängigkeit der synthetischen Verzögerung R($\lambda$) und die Wellenlängenabhängigkeit der Verzögerung r(n, $\lambda$) von mindestens einer der Flächeneinheiten die Gleichung (3) erfüllen:

$$R(628) - R(548) > r(n, 628) - r(n, 548) \ldots\ldots\ldots\ldots\ldots\text{Gleichung (3)}$$

8. Anzeigevorrichtung nach Anspruch 6, wobei die Beziehungen R(548) - R(447) > 0 und r(n, 548) - r(n, 447) < 0 bezüglich allen n erfüllt werden.

9. Anzeigevorrichtung nach einem der Ansprüche 1 bis 8, wobei jede der Verzögerungen der Vielzahl der Flächeneinheiten im Wesentlichen eine von zwei unterschiedlichen Verzögerungen ist.

10. Anzeigevorrichtung nach einem der Ansprüche 1 bis 9, wobei das optische Element eine Form eines Films, einer Folie oder einer Platte aufweist.

11. Anzeigevorrichtung nach einem der Ansprüche 1 bis 10, wobei die Anzeigezelle eine Flüssigkristallanzeigezelle ist.

12. Anzeigevorrichtung nach einem der Ansprüche 1 bis 11, wobei das optische Element zwischen zwei Polarisationsplatten angeordnet ist, die parallel zueinander sind, um die Betrachtungswinkeleigenschaft zu verbessern.

13. Anzeigevorrichtung nach einem der Ansprüche 1 bis 11, wobei polarisiertes Licht, das durch die Polarisationsplatte gegangen ist, auf das optische Element fällt.

**Revendications**

1. Dispositif d'affichage étant soit un écran à cristaux liquides, soit un écran électroluminescent (EL), ledit dispositif d'affichage comprenant un élément optique (1) avec une pluralité de régions unitaires (2) dans une direction parallèle à un plan d'incidence lumineuse de l'élément optique, les régions unitaires incluant une pluralité de régions unitaires (2-1, 2-2, ... 2-N) dont la différence de phase par rapport à la lumière d'une longueur d'onde définie diffère de 10 nm ou plus de la différence de phase de régions unitaires adjacentes par rapport à la lumière de la longueur d'onde définie, où:

au moins une plaque de polarisation, l'élément optique (1), et un élément où est disposée une pluralité de cellules d'affichage formant une unité d'affichage minimale sont prévus dans cet ordre ; une différence de dépendance en longueur d'onde est présentée entre la différence de phase r(n, $\lambda$) de chaque région unitaire et la différence de phase synthétisée R($\lambda$) de l'ensemble de la région (3) incluant toutes les régions unitaires (2-1, 2-2, ... 2-N), r(n, $\lambda$) indiquant la différence de phase d'une n$^{\text{ième}}$ région unitaire par rapport à une lumière de $\lambda$ nm en longueur d'onde, R($\lambda$) étant la différence de phase synthétisée par rapport à la lumière de $\lambda$ nm en longueur d'onde, et la différence de phase synthétisée R($\lambda$) de l'ensemble de la région correspondant à la différence de phase obtenue par observation macroscopique de l'ensemble de la région ;
ledit dispositif d'affichage étant **caractérisé**
**en ce que** l'élément optique comprend, dans une zone opposée à chacune des cellules d'affichage formant une unité d'affichage minimale, une pluralité de régions unitaires parmi des régions unitaires.

2. Dispositif d'affichage selon la revendication 1, où :

l'élément optique a la forme d'un plan de manière à causer une différence de phase homogène dans le plan, l'élément optique est conçu de telle manière que le plan est un plan d'incidence lumineuse, et que dans au moins une direction sur le plan, des cycles sont répétés, comprenant chacun une pluralité de régions unitaires successives avec au moins une biréfringence et/ou une épaisseur différentes parmi les régions unitaires, au moins une des régions unitaires étant une région biréfringente.

3. Dispositif d'affichage selon la revendication 2, où :

le dispositif d'affichage est un dispositif d'affichage à cristaux liquides ;
l'élément optique est utilisé comme plaque de différence de phase prévue sur le côté d'observateur ou le côté opposé d'une couche de cristaux liquides (18) du dispositif d'affichage à cristaux liquides (10) ; et
au moins un des cycles correspond à chacune des cellules d'affichage du dispositif d'affichage à cristaux liquides.

4. Dispositif d'affichage selon l'une des revendications 1 à 3, où,
dans le cas où l'élément optique est positionné entre une paire de plaques de polarisation dont les directions de polarisation sont parallèles l'une à l'autre, de telle manière qu'un axe lent de l'élément optique est tourné de 45° par rapport aux directions de polarisation des plaques de polarisation, si la transmittance est $I(n, \lambda)$ quand une lumière polarisée linéairement de $\lambda$ en longueur d'onde d'une des plaques de polarisation traverse une n$^{\text{ième}}$ région unitaire et l'autre plaque de polarisation, et si un rapport de région est $M(n)$ entre la n$^{\text{ième}}$ région unitaire et l'ensemble de la région en termes de plan d'incidence lumineuse, la différence de phase synthétisée $R(\lambda)$ est la différence de phase qui présente la transmittance exprimée par

$$\sum_{n=1}^{N} [M(n) \times I(n, \lambda)]$$

par rapport à lumière de $\lambda$ en longueur d'onde.

5. Dispositif d'affichage selon l'une des revendications 1 à 4, où la dépendance en longueur d'onde de la différence de phase synthétisée $R(\lambda)$ satisfait à l'équation (1) :

$$R(447) \leq R(548) \leq R(628) \dots\dots\dots\dots\dots\dots\dots\dots\dots\dots \text{équation (1)}$$

6. Dispositif d'affichage selon l'une des revendications 1 à 5, où la dépendance en longueur d'onde de la différence de phase synthétisée $R(\lambda)$ et la dépendance en longueur d'onde de la différence de phase $r(n, \lambda)$ d'au moins une des régions unitaires satisfont à l'équation (2) :

$$R(548) - R(447) > r(n, 548) - r(n, 447) \dots\dots\dots\dots\dots \text{équation (2)}$$

7. Dispositif d'affichage selon l'une des revendications 1 à 6, où la dépendance en longueur d'onde de la différence de phase synthétisée $R(\lambda)$ et la dépendance en longueur d'onde de la différence de phase $r(n, \lambda)$ d'au moins une des régions unitaires satisfont à l'équation (3) :

$$R(628) - R(548) > r(n, 628) - r(n, 548) \dots\dots\dots\dots\dots \text{équation (3)}$$

**8.** Dispositif d'affichage selon la revendication 6, où les relations R(548) - R(447) > 0 et r(n, 548) - r(n, 447) < 0 sont satisfaites par rapport à l'ensemble de n.

**9.** Dispositif d'affichage selon l'une des revendications 1 à 8, où chaque différence de phase de la pluralité de régions unitaires est essentiellement l'une de deux différences de phases non identiques.

**10.** Dispositif d'affichage selon l'une des revendications 1 à 9, où l'élément optique a la forme d'un film, d'une gaine ou d'une plaque.

**11.** Dispositif d'affichage selon l'une des revendications 1 à 10, où la cellule d'affichage est une cellule d'affichage à cristaux liquides.

**12.** Dispositif d'affichage selon l'une des revendications 1 à 11, où l'élément optique est disposé entre deux plaques de polarisation parallèles l'une à l'autre pour améliorer la caractéristique d'angle de vue.

**13.** Dispositif d'affichage selon l'une des revendications 1 à 11, où la lumière polarisée ayant traversé la plaque de polarisation est incidente à l'élément optique.

FIG. 1

(a)

Light-Incident Plane

1

3

(b)

2-1  2-2  2-3                    2-N-1  2-N

A                                          A

. . . . .

(c)

2-1        2-2        2-3                              2-N

| r(1, λ) | r(2, λ) | r(3, λ) | . . . . . | r(N, λ) |

FIG. 2

EP 2 159 610 B1

FIG. 3

FIG. 4

FIG. 5

## FIG. 6

## FIG. 7

FIG. 8

FIG. 9

(a)

(b)

2-1    2-2    2-3 · · · · ·

FIG. 10

(a)

(b)

FIG. 11

(a)

1

(b)

····· 2-1    2-2    2-3 ·····

FIG. 12

(a)

6

4

1

(b)

6

4

2-1    2-2    2-3  · · · · ·

FIG. 13

FIG. 14

# FIG. 15 (a)

Patterning Of Photosensitive Liquid Crystal

| Photoreactive Liquid Crystal |
| --- |
| Base Film |

⬇

Resist Pattern

Base Film

⬇ Optical Curing And Etching

Base Film

# FIG. 15 (b)

Patterning Of Inorganic Material

Resist Pattern

Base Film

⬇ Oblique Angle Vapor Deposition Of $Ta_2O_5$

Base Film

⬇ Lift Off

Base Film

## FIG. 16

(a)

90.0

180.0 — 0.0(deg.)

80.0(deg.)

270.0

Isoluminance countour

Pol_PC_137.5

Legend:
— 0.130000
— 0.120000
  0.100000
— 0.080000
— 0.070000
— 0.050000
— 0.040000
— 0.020000

(b)

90.0

180.0 — 0.0(deg.)

80.0(deg.)

270.0

Isoluminance countour

Pol_PC_220-100(ave)

Legend:
— 0.130000
— 0.120000
  0.100000
— 0.080000
— 0.070000
— 0.050000
— 0.040000
— 0.020000

(c)

90.0

180.0 — 0.0(deg.)

80.0(deg.)

270.0

Isoluminance countour

Pol_PC_220-50(ave)

Legend:
— 0.130000
— 0.120000
  0.100000
— 0.080000
— 0.070000
— 0.050000
— 0.040000
— 0.020000

(d)

90.0

180.0 — 0.0(deg.)

80.0(deg.)

270.0

Isoluminance countour

Pol_PC_300-100(ave)

Legend:
— 0.130000
— 0.120000
  0.100000
— 0.080000
— 0.070000
— 0.050000
— 0.040000
— 0.020000

FIG. 17

FIG. 18

Circularly
Polarized
Light

Reflection

External
Light

✕

Reflective
Light Is Blocked

Transparent Conductive
Film/Glass

EI Cell

λ/4 Retardation
Film

Polarization
Plate

FIG. 19

FIG. 20

FIG. 21

50 μm

FIG. 22

FIG. 23

FIG. 24

FIG. 25

FIG. 26

FIG. 27

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001249222 A
- JP 2587342Y U
- JP 8334619 A
- JP 7043707 A
- JP 2006520928 A

- WO 2006028275 A1
- WO 0137007 A
- JP 61146301 A
- JP 2751140 B
- JP 4305602 A

### Non-patent literature cited in the description

- **KUZUHARA NORIYASU ; UMEDA HIROKI ; SHIBUE TOSHIAKI.** *Development of New Retardation Film for VA-mode LCD-TVs,* 07 June 2007, http://konicaminolta.jp/about/research/technology_report/2006/pdf/introduce_009.pdf

- **FUJII SADAO.** Requested Properties and Material Design of Polymer Retardation Film. *Ekisyo (Liquid Crystal),* 2005, vol. 9 (4), 227-236